(19) Europäisches Patentamt / European Patent Office / Office européen des brevets

(11) **EP 3 563 062 B1**

(12) **EUROPEAN PATENT SPECIFICATION**

(45) Date of publication and mention of the grant of the patent:
**21.07.2021 Bulletin 2021/29**

(51) Int Cl.:
*F04D 13/06* (2006.01)     *F04D 15/00* (2006.01)
*F04D 29/046* (2006.01)     *F04D 29/66* (2006.01)

(21) Application number: **17826189.7**

(86) International application number:
**PCT/EP2017/083202**

(22) Date of filing: **18.12.2017**

(87) International publication number:
**WO 2018/122016 (05.07.2018 Gazette 2018/27)**

(54) **SENSOR ASSEMBLY AND METHOD FOR FAULT DETECTION IN PUMPS AND PUMP ASSEMBLY COMPRISING SUCH SENSOR ASSEMBLY**

SENSORANORDNUNG UND VERFAHREN ZUR FEHLERERKENNUNG IN PUMPEN SOWIE PUMPENANORDNUNG MIT SOLCH EINER SENSORANORDNUNG

ENSEMBLE CAPTEUR ET PROCÉDÉ DE DÉTECTION DE PANNE DE POMPES ET ENSEMBLE DE POMPE COMPRENANT UN TEL ENSEMBLE CAPTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.12.2016 EP 16207518**

(43) Date of publication of application:
**06.11.2019 Bulletin 2019/45**

(73) Proprietor: **Grundfos Holding A/S**
**8850 Bjerringbro (DK)**

(72) Inventor: **MUNK, Flemming**
**8800 Viborg (DK)**

(74) Representative: **Patentanwälte Vollmann Hemmer Lindfeld**
**Partnerschaft mbB**
**Wallstraße 33a**
**23560 Lübeck (DE)**

(56) References cited:
EP-A1- 1 298 511     EP-B1- 1 972 793
WO-A1-2015/197141     GB-A- 2 200 991
JP-A- 2016 017 418     US-A1- 2014 039 805

**Description**

**Field of invention**

The present invention relates to a sensor assembly for detecting both motor bearing faults and cavitation. The present invention furthermore relates to a method for detection of both motor bearing faults and cavitation in pumps. The invention also relates to a pump comprising such sensor assembly.

**Prior art**

It is known to provide pumps with sensors for detecting various faults having impact on pump performance. Some faults are very critical for the pump and thus important to detect in due time. Sensors have been developed to detect parameters including bearing status, motor speed, water hammering, unbalance level, cavitation status and dry run.

Due to the different origins and characteristics of these fault indication parameters, a lot of different sensors for detecting relevant parameters and faults have been developed. The optimal arrangement of a fault-indicating sensor depends heavily on the type of sensor. E.g. a dry run sensor should be arranged in the upper region of the conduct in which the fluid is expected to be present (due to the low density of air), whereas a cavitation sensor should be arranged near the impeller in a centrifugal pump, and the optimal position of a motor bearing fault sensor is at the motor. Faults in the electric motors of a pump can have huge financial consequences when the pump is used in a vital process. Bearing faults are one of the major motor failures, and therefore it is important to be able to detect bearing faults.

EP0742372B1 discloses a cavitation sensor arranged at the suction inlet close to the impeller of a centrifugal pump. This position is beneficial because it is possible to detect a powerful cavitation signal (large signal-to-noise ratio) and hereby detect cavitation.

EP1972793B1 discloses a pump assembly comprising a vibration sensor attached to a control box fastened to the motor housing. By mechanically attaching the vibration sensor in the proximity of the motor, it is possible to detect vibration signals that can be processed in order to detect motor bearing faults.

EP1298511A1 discloses a motorized pump system comprising an electrically driven pump and a plurality of sensors connected to a control system comprising a controller and diagnostics. It is required to apply several sensors arranged in various separate positions on the pump and the electrical motor, respectively. Since the different sensors require different positioning, it is not possible to arrange the sensors in the same position. In order to detect both motor bearing faults and cavitation in a pump assembly by using the system disclosed in EP1298511A1 it is required to have two separate sensors: one sensor for motor bearing fault detection and another sensor for cavitation.

Accordingly, it would be desirable to be able to use a single sensor assembly to detect both motor bearing faults and cavitation.

WO2015197141A1 discloses a method for detecting faults or operational parameters in a pump assembly by use of a handheld communication device that is arranged outside the pump housing. A microphone integrated in or connected to the handheld device is applied to detect sound signal. The handheld device may comprise an additional sensor such as an accelerometer. One problem associated with this method is that the sound signals must be collected in the same way in order to be capable of processing the data and provide useful results. In practice, it is not possible to control the position of the external device and the signals from the surroundings, in a manner sufficiently accurate, in order to apply the method to detect both motor bearing faults and cavitation. Even if the user tries to make several measurements independently of each other, it would be very difficult, if not impossible, to detect motor bearing faults and cavitation, if at all. Accordingly, it would be desirable to provide a single sensor and a method applying a single sensor that enables detection of both motor bearing faults and cavitation detection.

It is an object of the present invention to provide a single sensor assembly that can detect both motor bearing faults and cavitation. It is also an object of the present invention to provide an improved method for detection of faults in a pump assembly comprising an electric motor and a fluid pump.

SUMMARY OF THE INVENTION

The object of the present invention can be achieved by a sensor assembly as defined in claim 1 and by a method as defined in claim 9. Preferred embodiments are defined in the dependent subclaims, explained in the following description, and illustrated in the accompanying drawings.

The sensor assembly according to the invention is a sensor assembly configured to perform fault detection in a pump assembly comprising an electric motor and a fluid pump, wherein the sensor assembly comprises a housing configured to be attached into a bore provided in the pump, wherein one or more vibration sensing element(s) are arranged in the housing and that the sensor assembly comprises a calculation unit, wherein the calculation unit is configured to receive sensor signals from the vibration sensing element(s), wherein the calculation unit is configured to perform calculations and hereby detect both motor bearing faults and cavitation on the basis of the sensor signals provided by the one or more vibration sensing element(s).

Hereby it is possible to provide a single sensor assembly capable of detecting both motor bearing faults and cavitation based on the sensor signals provided by the one or more vibration sensing element(s). It is possible to apply a single sensor assembly capable to detect a plurality of parameters e.g. both motor bearing faults and cavitation.

In one embodiment the calculation unit is configured to carry out detection of motor bearing faults and cavitation at the same time.

In one embodiment the calculation unit is configured to carry out detection of motor bearing faults and cavitation on the basis of sensor signals provided by a single vibration sensing element. Said sensor signals will contain sufficient information to detect both motor bearing faults and cavitation by letting the calculation unit perform calculations and hereby detect both motor bearing faults and cavitation. Detection of motor bearing faults and cavitation may be carried out simultaneously or alternately. In a preferred embodiment, the calculation unit is configured to perform calculations and hereby detect motor bearing faults independently on the detection of cavitation. Accordingly, bearing faults and cavitation may be detected independently of each other at any desired time.

In one embodiment, a single vibration sensing element is arranged in the housing.

The calculation unit may be arranged inside the housing.

In a preferred embodiment according to the invention, the calculation unit is arranged outside the housing.

In one embodiment according to the invention the calculation unit is arranged outside the housing and is electrically connected to the one or more vibration sensing element(s).

In another embodiment, a communication unit configured to wirelessly transmit the sensor signals from the vibration sensing elements directly or indirectly to an external receiving unit is arranged in the housing or attached to the outside of the housing.

The external receiving unit may be arranged or be attached to the outside of the pump.

In a preferred embodiment, the sensor assembly is configured to communicate with a cloud-based server constituting a calculation unit.

The calculation unit is configured to detect both motor bearing faults. The calculation unit is provided with sensor signals provided by the one or more vibration sensing element(s). The calculation unit analyses (carries out calculations) the sensor signals and hereby the calculation unit detects when there is a motor bearing fault and when there is cavitation.

In one embodiment according to the invention, the sensor assembly is configured to communicate directly with a cloud-based server constituting a calculation unit. The communication may be carried out by means of a communication unit arranged in the housing or connected to the housing.

In another embodiment according to the invention, the sensor assembly is configured to communicate indirectly with a cloud-based server constituting a calculation unit. The communication may be carried out by means of an intermediate unit arranged outside the housing. Wherein, the intermediate unit comprising a communication unit and wherein the intermediate unit is connected to one or more structures (e.g. sensors) inside the housing through a wired or a wireless connection.

In a preferred embodiment, the calculations made by the calculation unit in order to detect both motor bearing faults and cavitation are carried out outside the housing.

It may be an advantage that the housing is configured to be arranged in a bore of a multistage pump.

The calculation unit is configured to receive sensor signals from vibration sensing elements and perform calculations and hereby detect motor bearing faults and cavitation.

The sensor assembly according to the invention is a sensor assembly configured to be mechanically attached to a pump and hereby enable vibration signals to travel from the motor bearing to the one or more vibration sensing elements and enable vibration signals to travel from the cavitation origin area near the inlet of the pump to the one or more vibration sensing elements. Accordingly, vibration signals from the faulty areas are capable of reaching the vibration sensing elements.

The pump assembly may be any type of pump that can experience cavitation. The electric motor may by any suitable type of motor connected and configured to drive the pump.

The sensor assembly comprises a housing having a geometric shape enabling the housing to be mechanically attached to the pump. The housing may have any suitable size and shape and may be attached to the pump by any suitable attachment means including bolts, hose clamps, corresponding tracks and protrusions or other mechanical engagement structures.

The one or more vibration sensing element(s) is/are arranged in or attached to the housing. It may be an advantage that the vibration sensing elements are arranged in the housing. In one embodiment according to the invention, a portion of the one or more vibration sensing element(s) protrudes from the housing. In one embodiment according to the invention, the one or more vibration sensing element(s) is/are directly or indirectly attached to the outside surface of the housing. In a preferred embodiment according to the invention the one or more vibration sensing element(s) is/are arranged inside the housing in such a manner that the housing encases the one or more vibration sensing element(s).

The sensor assembly comprises a calculation unit configured to receive sensor signals from the one or more vibration sensing element(s) and perform calculations and hereby detect motor bearing faults and cavitation.

The calculation unit may be arranged inside the housing. The calculation unit may be arranged outside the housing. In a preferred embodiment according to the invention the calculation unit is arranged outside the housing and is electrically connected to the one or more vibration sensing element(s).

In another embodiment according to the invention, the calculation unit is provided as a cloud computing solution. It may be an advantage that the calculations are carried out at one or more predefined servers. Hereby, it is possible to access the data externally. Moreover, it is possible to lower the cost for the end user of the sensor assembly because the end user does not have to pay for a calculation unit being a separate hardware component.

The sensor assembly according to the invention constitutes a fault detection system comprising a number of sensors and a calculation unit.

The housing is configured to be attached to a bore provided in the pump. Hereby, it is possible to attach the housing to the pump in an easy and reliable manner.

In one embodiment, according to the invention, the housing comprises an outer threaded portion configured to fit a threaded bore provided in the pump. Hereby, it is possible to attach the housing in an easy and safe manner. Moreover, vibration signals can be detected by the one or more vibration sensing element(s).

It may be beneficial that the housing is configured to be attached to the pump in a zone in which the amplitude of signals of the vibrations generated by faulty motor bearings and the amplitude of signals generated in case of cavitation in the suction side of the pump have a magnitude sufficiently large to be detected by the vibration sensing element(s).

In a preferred embodiment according to the invention, the housing is configured to be inserted into a bore placed in a zone of the pump, in which zone the amplitude of signals of the vibrations generated by faulty motor bearings and the amplitude of signals generated in case of cavitation in the suction side of the pump have a magnitude sufficiently large to be detected by the vibration sensing element(s). Hereby, it is possible to provide vibration signal detection having a signal-to-noise ratio allowing the vibration signals to be filtered and processed in order to carry out motor bearing fault detection and cavitation detection.

It may be beneficial that a thermosensitive sensor is arranged in the housing, wherein the thermosensitive sensor is arranged to detect the temperature of fluid being pumped by the pump. The thermosensitive sensor may preferably be attached in the distal end of a housing inserted into a bore in the pump. It may be an advantage that the thermosensitive sensor is brought into contact with a material having a high thermal conductance in order to provide a valid temperature measurement.

It may be beneficial that the housing is a one-piece body.

It may be advantageous that the sensor assembly is configured to perform fault detection in a pump assembly comprising an electric motor and a multistage centrifugal pump.

In one embodiment according to the invention, the sensor assembly is configured to perform fault detection in a pump assembly comprising an electric motor and a multistage centrifugal pump configured to be vertically arranged.

In another embodiment according to the invention, the sensor assembly is configured to perform fault detection in a pump assembly comprising an electric motor and a multistage centrifugal pump configured to be horizontally arranged.

It may be an advantage that the housing is arranged in the top portion of the housing (e.g. the pump head) of the pump in order to be able to collect vibration signals originating from both motor bearing faults and cavitation.

In one embodiment of the invention, the housing is arranged in the pump head of a multistage centrifugal pump. Hereby, it is possible to collect vibration signals originating from both motor bearing faults and cavitation, in a manner in which the signals have sufficiently large amplitude (magnitude).

It may be advantageous that the sensor assembly is configured to detect the speed of the pump by means of the calculation unit and sensor signals from the vibration sensing element(s) or another sensing element(s).

It may be beneficial that the vibration sensitive element is an accelerometer configured to detect accelerations in at least one dimension. It may be an advantage that the accelerometer is mechanically attached to the housing by means of a rigid connection.

It one embodiment of the invention, the vibration sensitive element is a microphone. By attaching the microphone mechanically to the housing, it is possible to detect vibration signals by using the microphone. By mechanically attaching the microphone to the housing, the microphone will experience vibrations corresponding to the vibrations that the housing is exposed to.

It may be beneficial that the calculation unit is configured to receive raw (unprocessed/unfiltered) sensor signals from the sensing elements and perform calculations on the basis of these signals.

In one embodiment according to the invention, the sensor signals are processed before they are received by the calculation unit. It is possible to apply any suitable type of signal processing including digital filters.

It may be an advantage that the calculation unit comprises a processing unit configured to receive the signals from the sensing elements, wherein the calculation unit is further configured to process the signals and hereby carry out bearing fault detection by using a frequency analysis, wherein the calculation unit furthermore is configured to carry out cavitation detection by using spectral analysis and determining if the spectral level increases in a predefined frequency band.

Hereby, it is possible to carry out both bearing fault detection and cavitation detection based on vibration signals detected by a single vibration sensing element.

In one embodiment, the frequency analysis is a Cepstral analysis.

It may be beneficial that the predefined frequency band is within the range 10-20 kHz. In one embodiment according to the invention the calculation unit is configured to carry out cavitation detection by using spectral analysis and determining if the spectral level increases within the range 10-20 kHz.

In one embodiment according to the invention, the sensor assembly comprises two vibration sensing elements. Accordingly, it is possible to apply different vibration sensing elements to detect motor bearing faults and cavitation, respectively.

It may be advantageous that the calculation unit is arranged in a separate box arranged outside the pump, wherein the calculation unit is electrically connected to the vibration sensing element through an electric cable. Hereby, it is possible to supply the vibration sensing element with electric power via the cable. Moreover, it is possible to service the calculation unit without affecting the housing or the sensing elements. Further, it is possible to replace the calculation unit and still apply the same housing. In one embodiment, the calculation unit is arranged in a control box attached to the motor housing.

It may be beneficial that a transmitter unit configured to wirelessly transmit the sensor signals directly or indirectly (e.g. via the Internet) from the vibration sensing elements directly or indirectly (e.g. via the Internet) to an external receiving unit is arranged in the housing or attached to the outside of the housing. Hereby, it is possible to wirelessly transmit signals from the vibration sensing elements to an external receiving unit that can process the signals. The transmitter unit may comprise a radio transmitter configured to communicate with a communication module in the receiving unit.

In one embodiment according to the invention, a communication unit configured to communicate (including to transmit and receive signals) with an external communication unit is arranged in the housing or attached to the outside of the housing. Hereby, it is possible to send signals wirelessly from the vibration sensing elements to the receiving unit and to receive information (e.g. a stop signal) transmitted from the external communication unit.

Signals sent from a transmitter unit or a communication unit may be filtered by using any suitable filter including a low-pass filter or a high-pass filter.

It may be an advantage that the sensor assembly comprises an intermediate box provided with a communication unit configured to communicate wirelessly, wherein the intermediate box is electrically connected to the sensing elements through an electric cable, wherein the intermediate box is configured to communicate wirelessly, either directly with an external receiving unit or indirectly with an external receiving unit via the Internet.

Hereby, it is possible to carry out calculations (processing) on an external device (e.g. a server or a smartphone). Accordingly, it is possibly to reduce the complexity and cost of the sensor assembly because an external device (e.g. a server or a smartphone) can be used as the calculation unit.

The communication unit may preferably be configured to receive signals from an external device. Such signals may include a stop signal sent to a control box electrically connected to the motor in case of detection of a motor bearing fault or cavitation.

The external receiving unit may be a smartphone, a server, a laptop computer (PC), a personal digital assistant (PDA), a tablet or a smartwatch.

It may be beneficial that the sensor assembly comprises a display unit configured to display one or more of the parameters calculated by the calculation unit. The sensor assembly may comprise a display unit attached to the housing.

In one preferred embodiment according to the invention, a display unit is an integrated part of or attached to a box arranged outside the pump, wherein the box is electrically connected to the vibration sensing element through an electric cable. It may be beneficial that the display unit is an integrated part of or attached to a box comprising a calculation unit, wherein the box is arranged outside the pump, and wherein the box is electrically connected to the vibration sensing element by means of an electric cable.

It may be advantageous that the calculation unit is arranged in a separate box arranged outside the pump, wherein the calculation unit is electrically connected to the vibration sensing element through an electric cable. Hereby, it is possible to supply the vibration sensing element with electric power via the cable. Moreover, it is possible to service the calculation unit without affecting the housing or the sensing elements. Furthermore, it is possible to replace the calculation unit and still apply the same housing. In one embodiment, the calculation unit is arranged in a control box attached to the motor housing.

In one embodiment according to the invention, the calculation unit and the display unit are attached to the housing. Hereby, it is possible to provide a compact sensor assembly.

It may be beneficial that the calculation unit and the display unit are arranged in a one-piece body.

In one embodiment according to the invention, the calculation unit, the display unit and the housing are shaped as a one-piece body.

It may be advantageous that a printed circuit board (PCB) is provided in the housing, and that the sensing elements are electrically connected to the printed circuit board. It is possible to carry out a filtering process by means of the electronic components of the PCB.

It may be an advantage that a socket is arranged in the proximal end of the housing, wherein the sensor assembly comprises a plug configured to be mechanically and electrically connected to the socket. Hereby, it is possible to electrically and mechanically connect the housing and the sensing elements to an external box through an electric cable provided with said plug. Accordingly, the invention provides a simple and user-friendly way of electrically connecting the housing and the sensing elements to an external box. Moreover, the sensing elements may be energized through the cable. Thus, the cable may be used to transfer electrical signals from the sensing elements and simultaneously be used to provide electrical power to the sensing elements.

It may be beneficial that the housing is provided with a transmitter unit configured to wirelessly transmit signals received from the sensing elements. The transmitter unit may transmit wireless signals to an external device such as a smartphone or another device capable of forwarding the signals to an additional receiving device (e.g. a server). In this manner, it is possible to perform processing and calculations in the external device or the additional receiving device.

In one embodiment according to the invention, the calculation module is arranged in the housing. Accordingly, the signal processing can be carried out in the calculation module in the housing, and thus these processed signals can be transferred to a box comprising a display unit configured to display one or more predefined parameters.

It may be an advantage that the housing is provided with an inner threaded portion in its proximal end. Hereby, the housing can be threaded into a threaded bore in order to firmly attach the housing to a mechanical structure of the pump assembly. Accordingly, vibration signals can be transmitted through the mechanical structures of the pump assembly towards the housing. Therefore, the vibration sensing elements can detect the vibration signals.

In a preferred embodiment according to the invention, the housing comprises a bottom wall provided in the distal end of the housing, wherein the thickness of the bottom wall is smaller than the thickness of the remaining wall portions of the housing. Hereby, it is possible to provide optimum conditions in order to carry out temperature measurements by using a thermosensitive sensor arranged in the housing. Moreover, when the housing is provided with a thin distal wall structure, it is possible to detect dry run by means of an ultrasonic sensor provided in the distal end of the housing.

It may be an advantage that a nut structure is integrated in the proximal end of the housing. Hereby, the nut structure can be applied as an engagement structure during tightening of the housing while the housing is being attached in a threaded bore in a pump. It may be an advantage that the nut structure is hexagonal.

In an embodiment according to the invention, the sensor assembly comprises a housing configured to be mechanically attached to a pump head provided with a threaded bore configured to receive the housing. By arranging the housing in a bore arranged in the pump head, it is possible to receive significantly large vibration signals originating from the motor bearing and from cavitation.

It may be an advantage that an ultrasonic dry run sensing element is arranged in the distal end of the housing. Hereby, it is possible to carry out dry run detection in an efficient manner.

In a preferred embodiment according to the invention, an ultrasonic dry run sensing element and a thermosensitive sensor are arranged in the same die. Hereby, it is possible to reduce the size and the total production cost of the ultrasonic dry run sensing element and the thermosensitive sensor. It may be beneficial that the ultrasonic dry run sensing element and the thermosensitive sensor are arranged in the same die and arranged in the distal end of the housing, wherein the housing is configured to be inserted into a bore provided in the pump, wherein the bore creates access to the fluid being pumped by the pump.

It may be advantageous that an ultrasonic dry run sensing element and a vibration sensitive element are arranged in the same die. Hereby, it is possible to reduce the size and production cost of the ultrasonic dry run sensing element and the vibration sensitive element. It may be beneficial to arrange the ultrasonic dry run sensing element and the vibration sensitive element in the same die at the distal end of the housing in order to provide the most optimum detection conditions.

In one embodiment according to the invention, an ultrasonic dry run sensing element, a vibration sensitive element and a thermosensitive sensor are arranged in the same die. Hereby, it is possible to provide a compact and cost-efficient sensor assembly capable of detecting dry run, motor bearing faults, cavitation and the temperature of the fluid being pumped.

It may be an advantage that the ultrasonic dry run sensing element is arranged in an ultrasound gel. Hereby, it is possible to achieve a good acoustical connection between the ultrasonic dry run sensing element and the wall member being in contact with the fluid being pumped.

It may be beneficial that the housing is at least partly filled with resin in order to make the sensor assembly suitable for vibration measurements. In a preferred embodiment according to the invention, the housing is totally filled with resin in order to optimize the mechanical properties of the housing and thereby enable vibration signals to be detected by the vibration sensors in the most efficient manner.

In one embodiment according to the invention, the housing comprises a battery. Hereby, it is possible to provide the sensing elements (vibration sensing elements, an ultrasonic dry run sensing element and a thermosensitive sensor) with electric power from the battery.

In another embodiment according to the invention, the display unit comprises a battery. Hereby, the sensing elements (vibration sensing elements, an ultrasonic dry run sensing element and a thermosensitive sensor) can be provided with electric power from the battery by means of an electric connection (e.g. a wired connection) between the battery and the sensing elements.

In a preferred embodiment according to the invention, a separate box is connected to the power circuit of the pump or of the motor and to the sensing elements (vibration sensing elements and optionally an ultrasonic dry run sensing element and/or a thermosensitive sensor) in the housing. Hereby, the sensing elements can be powered by the same power source as the pump.

It may be an advantage that the sensor assembly comprises a display unit being electrically connected to the power circuit of the pump or of the motor and to the sensing elements (vibration sensing elements and optionally an ultrasonic dry run sensing element and/or a thermosensitive sensor) in the housing. Accordingly, the pump and the sensing elements can be powered by the same power source.

It may be an advantage to apply a pump having a sensor assembly according to the invention. Such a pump is safe to use due to the sensor assembly.

The method according to the invention is defined in appended claim 9 and is a method for detection of faults in a pump assembly comprising an electric motor and a fluid pump, wherein the method comprises the steps of providing sensor signals from at least one vibration sensing element, wherein the method comprises the following steps:

- applying a calculation unit receiving sensor signals from the vibration sensitive element(s);
- processing the sensor signals;
- using a frequency analysis to detect motor bearing faults,

wherein the sensor signals are detected by means of a vibration sensing element attached into a bore provided in the pump.

Hereby, it is possible to provide an improved method for detection of faults in a pump assembly comprising an electric motor and a fluid pump. The method can be carried out by applying a single sensor assembly (e.g. a single vibration sensing element) attached to the pump.

The method according to the invention is a method for detection of faults including motor bearing faults and cavitation in a pump assembly comprising an electric motor and a fluid pump.

The method may, however, also be configured to detect additional parameters, including detection of dry run and the temperature of the fluid being pumped by the fluid pump.

The method comprises the step of providing sensor signals from at least one vibration sensing element. The sensor signals are detected by means of a vibration sensing element mechanically attached to the pump. Accordingly, it is possible to provide a method that does not require involvement of a user. Accordingly, the method is suitable for being implemented as an autonomous system, whereas the prior art methods require involvement of a user.

The method applies a calculation unit that is configured to receive sensor signals from the vibration sensitive element(s). Hereby, the calculation unit can process the sensor signals. Processing of the sensor signals may include any suitable type of processing including low-pass filtering and high-pass filtering.

The sensor assembly comprises a housing having a geometric shape enabling the housing to be mechanically attached to the pump, wherein the housing is configured to be attached to a bore provided in the pump.

In a preferred embodiment according to the invention the method comprises the step of arranging the sensor assembly in a threaded bore provided in the pump. Hereby, a firm attachment of the sensor assembly. Moreover, the sensor assembly is always position in the correct place, hereby enabling optimum measurements.

The method furthermore uses a frequency analysis to detect motor bearing faults. Hereby, it is possible to separate noise (e.g. from the motor and the pump) and detect periodic signals representing motor bearing faults.

In one embodiment, the frequency analysis is Cepstral analysis. Cepstral analysis of a vibration signal can be carried out by taking the inverse Fourier transform of the log-magnitude Fourier spectrum of the vibration signal. It may be beneficial to apply a high-pass filtering of the frequency domain before carrying out the Fourier transformation of the frequency domain in order to eliminate influences of the motor design.

According to the invention, the method comprises the step of using spectral analysis to detect cavitation by determining if the spectral level increases in a predefined frequency band.

Hereby, it is possible to detect cavitation.

In a preferred embodiment according to the invention, the method comprises the step of using spectral analysis to detect cavitation by determining if the spectral level increases within the range 10-20 kHz.

It may be beneficial to apply a method that comprises the step of applying a bearing fault detection method based on a predefined sound analysis carried out to categorize sound signals into a plurality of classes/groups, wherein corresponding sensor signals are recorded, wherein the sound signals are evaluated by using a predefined benchmarking method, benchmarking each sound signal with a score or category, hereby categorizing the sound signal and the corresponding sensor signals into the classes/groups.

Hereby, it is possible to apply the predefined sound analysis as a tool to carry out bearing fault detection.

The sound analysis may be carried out in different ways. In one embodiment according to the invention, the sound analysis may be human-assisted, wherein a number of trained motor bearing service employees (preferably a plurality of employees) carry out sound analysis based on their experiences in order to categorize sound signals into a plurality of classes/groups, wherein corresponding (vibration) sensor signals are recorded, wherein the sound signals are evaluated by using a predefined benchmarking method, benchmarking each sound signal with a score or category, hereby categorizing the sound signals and the corresponding (vibration) sensor signals into the classes/groups.

The sound analysis may alternatively be based on an automated method based on data provided by a human-assisted method.

It may be an advantage that the method comprises the step of applying a data table comprising pre-recorded signals or signal patterns associated with known pump error types, wherein the method moreover comprises the step of comparing sensor signals with pre-recorded signals or signal patterns in order to associate the sensor signals with a known sensor error type.

Hereby, it is possible to identify errors/faults by making a comparison of pre-recorded signals or signal patterns and sensor signals.

The sensor signals may be provided as real time signals.

In one embodiment of the method according to the invention, a feature matrix is generated on the basis of the predefined sound analysis, wherein the feature matrix comprises a plurality of rows or columns corresponding to a number of feature vectors, wherein each feature vector is generated on the basis of a detected sensor signal, wherein the detected sensor signal is converted to a feature vector, wherein the measured sensor signal detected by the at least one vibration sensing element is converted to a measured feature vector and compared to the feature vectors of the feature matrix by using a distance measurement, wherein the distance measurement determines the distances between the point defined by the measured feature vector and the points defined by the feature vectors of the feature matrix, wherein the point defined by the feature vector of the feature matrix having the smallest distance to the point defined by the measured feature vector is found, and wherein its score or category is adapted by the feature vector converted on the basis of the measured sensor signal detected by the at least one vibration sensing element.

In another embodiment of the method according to the invention, a feature matrix is generated on the basis of the predefined sound analysis, wherein the feature matrix comprises a plurality of rows or columns corresponding to a number of feature vectors, wherein each feature vector is generated on the basis of a detected sensor signal, wherein the detected sensor signal is converted to a feature vector, wherein the measured sensor signal detected by the at least one vibration sensing element is converted to a measured feature vector and compared to the feature vectors of the feature matrix by using a distance measurement, wherein the distance measurement determines the distances between the point defined by the measured feature vector and the points defined by the feature vectors of the feature matrix, wherein a predefined number of points defined by the feature vector of the feature matrix having the smallest distance to the point defined by the measured feature vector are found, and wherein the score(s) or categories or a calculated average of these is adapted by the feature vector converted on the basis of the measured sensor signal detected by the at least one vibration sensing element.

Hereby, it is possible to apply a number of validated and pre-categorized signals to categorize detected sensor signals in an automated manner. As the number of pre-categorized signals increases, the validity of the method increases. Accordingly, it is possible to provide an extremely valid method by increasing the number of pre-categorized signals.

It may be beneficial that the feature vector comprises a number of components each representing a scalar derived on the basis of a sensor signal or a signal processed on the basis of the sensor signal.

Accordingly, the components of the components may include Cepstral, coefficients, spectral coefficients or parameters such as skewness, kurtosis, variance, moment, median, root mean square (RMS) or combinations hereof. The parameters such as skewness, kurtosis, variance, moment, median and RMS may be calculated of any predefined section of either the sensor signal or a signal processed on the basis of the sensor signal.

Accordingly, it is possible to extract the important information from the Cepstral analysis and apply the information when applying the feature matrix to categorize incoming sensor signals

Based on the power spectrum (also called "spectral diagram"; made by a spectral analysis) and on the Cepstral diagram (also referred to as "Cepstrum"; made by a Cepstral analysis), it is possible to extract a number of predefined features. These features are scalars constituting a feature vector. Each feature represents information extracted on the basis of either the power spectrum or the Cepstrum. In one embodiment according to the invention, the features represent values calculated on the basis of integration or the sum of predefined areas of the power spectrum or the Cepstrum. These values may be calculated by dividing the power spectrum and the Cepstrum in a predefined number of sections and using each section to calculate a feature. Accordingly, the number of features may be selected in order to achieve sufficient information to carry out a categorization of the vibration signal on the basis of the feature vector. In one embodiment according to the invention the feature vector contains 10-1000 features. It may be beneficial that the feature vector contains 20-500 features. In one embodiment according to the invention, the feature vector contains 30-300 features. In another embodiment according to the invention, the feature vector contains 50-150 features. In a further embodiment according to the invention the feature vector contains 80-120 features.

It may be an advantage that the fault detection is carried out by using a remotely arranged calculation unit by using one or more external devices.

Hereby, it is possible to achieve a flexible method that enables the verification data (achieved on the basis of the predefined sound analysis) to be regularly updated (including adding additional data).

It may be advantageous that a distance measurement is carried out by using a remotely arranged calculation unit by using one or more external devices. Hereby, it is possible to achieve great freedom of design when carrying out the method.

It may be beneficial that the method comprises the step of establishing and training an artificial neural network or a fuzzy network to carry out bearing fault detection, wherein the artificial neural network or fuzzy network comprises information established on the basis of the predefined sound analysis. Hereby it is possible to optimize the method.

It may be an advantage that the method comprises the step of applying data from an ultrasonic sensor to detect dry run conditions. Hereby, it is possible to provide an improved method that also provides dry run detection.

It may be beneficial that the method comprises the step of applying data from a thermosensitive sensor. Hereby, it is possible to provide an improved method that also detects the temperature of the fluid being pumped by the pump.

It may be advantageous that the method comprises the step of sending a stop signal in order to stop the electric motor of the fluid pump. This feature may protect the pump assembly in case of a critical fault such as dry run, cavitation or motor bearing faults.

It may be beneficial that the method comprises the step of establishing an envelope on the basis of the Cepstral domain signal, wherein a motor bearing fault is defined to be present when the amplitude of the envelope exceeds a predefined level.

It may be advantageous that the sensor assembly is configured to carry out a method according to the invention.

## Description of the Drawings

The invention will become more fully understood from the detailed description given herein below. The accompanying drawings are given by way of illustration only, and thus, they are not limitative of the present invention. In the accompanying drawings:

Fig. 1A      shows a schematic top view of a housing of a sensor assembly according to the invention;
Fig. 1B      shows a schematic, cross-sectional side view of the housing shown in Fig. 1A;
Fig. 1C      shows a schematic side view of the housing shown in Fig. 1A and in Fig. 1B;
Fig. 2A      shows a schematic, cross-sectional side view of one embodiment of a housing of a sensor assembly according to the invention;
Fig. 2B      shows a schematic, cross-sectional side view of another embodiment of a housing of a sensor assembly according to the invention;
Fig. 2C      shows a schematic, cross-sectional side view of a further embodiment of a housing of a sensor assembly according to the invention;
Fig. 2D      shows a schematic perspective view of the sensing element shown in Fig. 2C;
Fig. 3      shows a schematic, cross-sectional side view of a multistage pump provided with a sensor assembly according to the invention;
Fig. 4A      shows a schematic, perspective, exploded view of the elements of a housing of a sensor assembly according to the invention;
Fig. 4B      shows a schematic, perspective, cross-sectional view of the elements of a housing of a sensor assembly according to the invention;
Fig. 5A      shows a spectral diagram based on a spectral analysis of data from an accelerometer attached to a motor of a pump, wherein the detected level is plotted as function of frequency;
Fig. 5B      shows a spectral diagram based on a spectral analysis of data from a sensor assembly according to the invention provided with an accelerometer used as a vibration sensing element;
Fig. 5C      shows a spectral diagram based on a spectral analysis of data from a sensor assembly according to the invention provided with a microphone used as a vibration sensing element;
Fig. 6A      shows a Cepstral diagram based on a Cepstral analysis carried out on the basis of data from an accelerometer attached to a motor of a pump, wherein the detected level is plotted as function of quefrency

Fig. 6B   shows a Cepstral diagram based on a Cepstral analysis carried out on the basis of data from a sensor assembly according to the invention provided with an accelerometer used as a vibration sensing element, wherein the detected level is plotted as function of quefrency;

Fig. 6C   shows a Cepstral diagram based on a Cepstral analysis carried out on the basis of data from a sensor assembly according to the invention provided with a microphone used as a vibration sensing element, wherein the detected level is plotted as function of quefrency;

Fig. 7A   shows a spectral diagram based on a spectral analysis of data from an accelerometer attached to a motor of a pump, during cavitation and under normal operation, wherein the detected level is plotted as function of frequency;

Fig. 7B   shows a spectral diagram based on a spectral analysis of data from a sensor assembly according to the invention provided with an accelerometer used as a vibration sensing element, during cavitation and under normal operation, wherein the detected level is plotted as function of frequency;

Fig. 8A   shows a schematic, side view of the elements of a sensor assembly according to the invention, wherein the housing is arranged in a bore of a multistage pump;

Fig. 8B   shows a schematic, side view of the elements of another sensor assembly according to the invention, wherein the housing is arranged in a bore of a multistage pump and wherein the sensor assembly is configured to communicate with a cloud-based server;

Fig. 8C   shows a schematic, side view of the elements of a further sensor assembly according to the invention, wherein the housing is arranged in a bore of a multistage pump and wherein the sensor assembly is configured to communicate with a cloud-based server;

Fig. 8D   shows a schematic, side view of the elements of a sensor assembly according to the invention, wherein the housing is arranged in a bore of a multistage pump and wherein the sensor assembly comprises a display attached to the housing;

Fig. 9A   shows a schematic, perspective, cross-sectional view of the elements of a housing of a sensor assembly according to the invention;

Fig. 9B   shows a schematic, perspective, cross-sectional view of the elements of a housing of another sensor assembly according to the invention;

Fig. 10   shows a schematic, cross-sectional side view of a multistage pump provided with a sensor assembly according to the invention;

Fig. 11A   shows a schematic view of a sound analysis carried out to categorize sound signals into a plurality of classes/groups, wherein corresponding sensor signals are recorded, and the sound signals are evaluated by using a predefined benchmarking method;

Fig. 11B   shows a schematic view of a method that comprises the step of applying a data table comprising pre-recorded signals or signal patterns associated with known pump error types and comparing sensor signals with pre-recorded signals or signal patterns in order to associate the sensor signals with a known sensor error type;

Fig. 12A   shows a schematic view of the process of associating a detected sensor signal with a known sensor error type by using a method according to the invention and

Fig. 12B   shows a close-up view of the process illustrated in Fig. 12A.

**Detailed description of the invention**

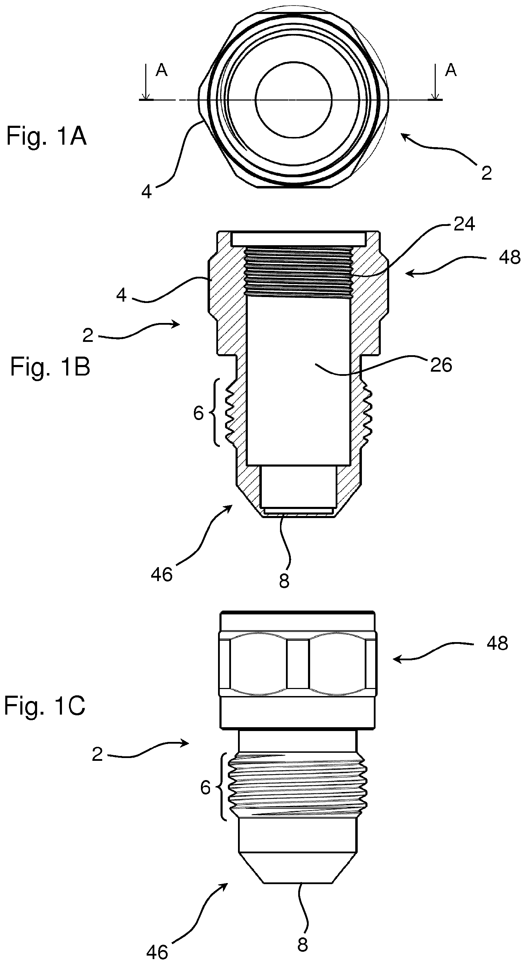

Referring now in detail to the drawings for the purpose of illustrating preferred embodiments of the present invention, a housing 4 of a sensor assembly 2 of the present invention is illustrated in Fig. 1A. Fig. 1A illustrates a schematic top view of a housing 4 of a sensor assembly 2 according to the invention. The housing 4 comprises a hexagonal nut-structure that is integrated in the proximal end of the housing 4. Accordingly, the nut structure can be applied as an engagement structure during mounting of the housing 4 into a threaded bore in a pump. A section line A is indicated.

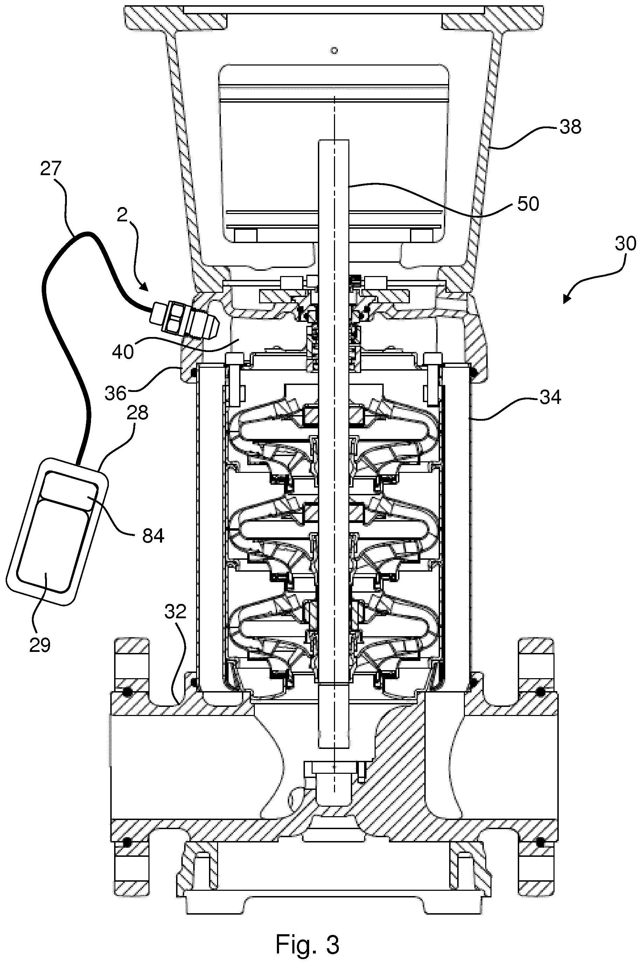

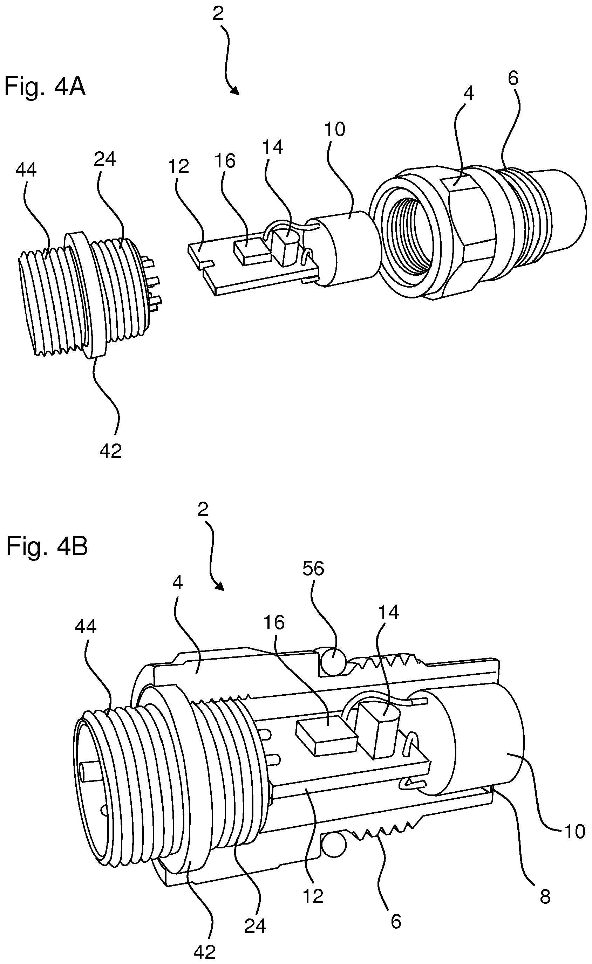

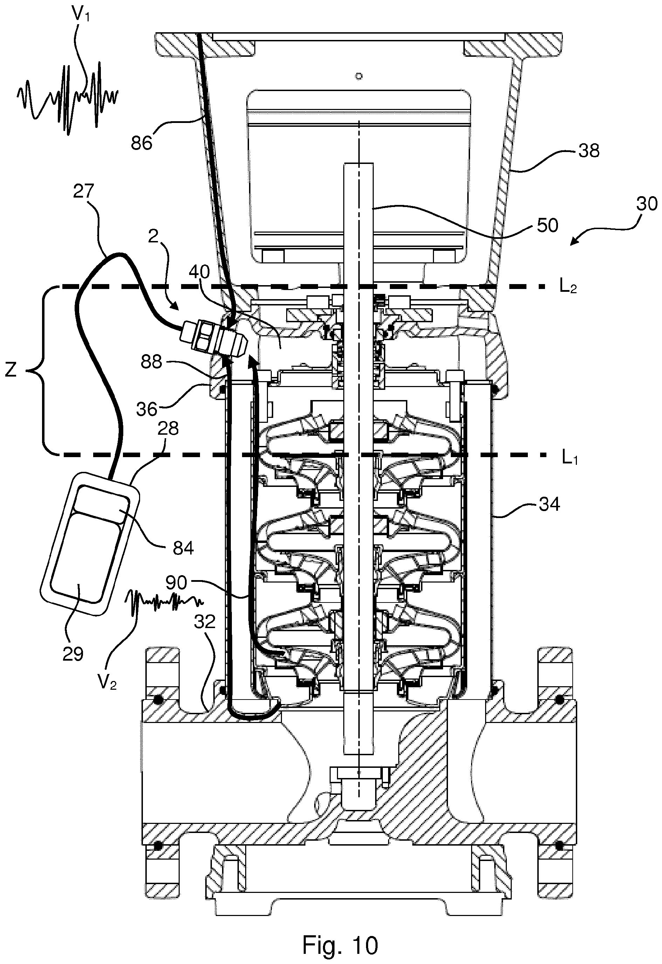

Fig. 1B illustrates a schematic, cross-sectional side view of the housing 4 shown in Fig. 1A. It can be seen that the housing 4 comprises a bottom wall 8 having a thickness that is smaller than the thickness of the remaining wall portions of the housing 4. The bottom wall 8 is arranged in the distal end 46 of the housing 4 and is formed as a plate-shaped end portion. A threaded portion 6 is provided at the outer structure of the part of the housing 4 that is configured to be inserted into a threaded bore. The threads of the treaded portion 6 are configured to engage with inner threads of a corresponding bore (see Fig. 3 and Fig. 10). The hexagonal nut structure protrudes from the proximal end 48 of the housing 4. The housing 4 is provided with a hollow inner portion 26 configured to receive a number of sensor members. The hollow inner portion 26 is provided with an inner threaded portion 24 that has been brought into engagement with the treads of a threaded connection structure. This connection structure may (as shown in Fig. 4B) be provided with electrical socket structures for receiving an electrical plug (e.g. provided in the distal end of an electric cable).

Fig. 1C illustrates a schematic side view of the housing 4 shown in Fig. 1A and in Fig. 1B. It can be seen that the hexagonal nut structure protrudes from the proximal end 48 of the housing 4, and that the hexagonal nut-structure has a larger width that the more distal portion of the housing 4. The bottom wall 8 is arranged as an end portion arranged next to a conical portion that is arranged next to a cylindrical portion provided with a threaded portion 6.

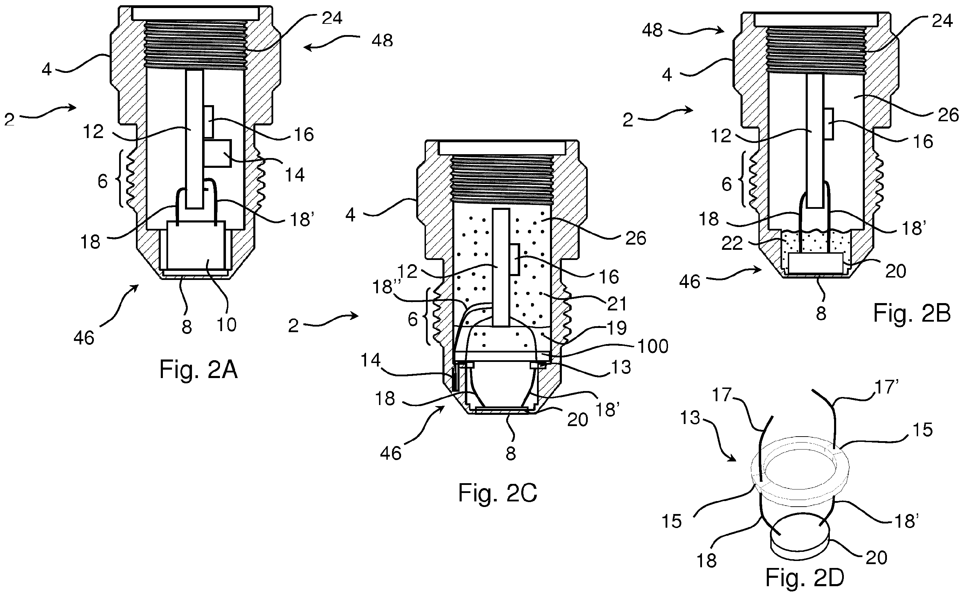

Fig. 2A illustrates a schematic, cross-sectional side view of one embodiment of a housing 4 of a sensor assembly 2 according to the invention. The housing 4 corresponds to the one shown in Fig. 1B. Accordingly, some of the structures of the housing 4 have already been defined with reference to Fig. 1B. Several electric elements are arranged in the hollow inner portion 26 of the housing 4. A PCB 12 is arranged in the hollow inner portion 26. The PCB 12 is centrally arranged. However, it may be arranged differently in order to meet specific requirements. A thermosensitive sensor 14 and vibration sensing element 16 are electrically connected to the PCB 12. An ultrasonic sensor 10 is arranged in the distal portion of the hollow inner portion 26. The ultrasonic sensor 10 is arranged close to the distal end portion of the housing 4 close to the bottom wall 8. Accordingly, the ultrasonic sensor 10 can be used as a dry run sensor configured to detect if there is air or a liquid in the space into which the distal end 48 of the housing 4 is inserted. The ultrasonic sensor 10 is electrically connected to the PCB 12 by means of two legs 18, 18'. Although not shown, it may be an advantage that the housing 4 is filled with resin in order to enable vibration signals to be detected by the vibration sensing element 16 in the most efficient manner.

Fig. 2B illustrates a schematic, cross-sectional side view of an embodiment of a housing 4 of a sensor assembly 2 according to the invention corresponding to the one shown in Fig. 2A. Accordingly, some of the structures of the housing 4 have already been defined and explained with reference to Fig. 2A. A PCB 12 is centrally arranged in the hollow inner portion 26, however, it may be arranged differently (e.g. close to one of the side walls) if desired. A vibration sensing element 16 is electrically connected to the PCB 12. A sensing element 20 comprising a thermosensitive sensor and an ultrasonic sensor is arranged in the distal portion of the hollow inner portion 26. The sensing element 20 is a combined sensing element 20 arranged in the same sensor housing member. It can be seen that the sensing element 20 is brought into contact with the bottom wall 8 in the distal end 46 of the housing 4. Accordingly, the thermal resistance can be minimised in order to optimize the temperature measurement conditions by using the thermosensitive sensor. Similarly, this position enables optimal conditions for providing dry run detection by using the ultrasonic sensor of the sensing element 20. The bottom wall 8 may preferably be made in a material having a high thermal conductance. In a preferred embodiment according to the invention, the housing 4 including the bottom wall 8 is made in steel, e.g. stainless steel. The sensing element 20 is arranged in a cavity filled with an ultrasound gel 22. Hereby, it is possible to achieve a good acoustical connection between the ultrasonic sensor of the sensing element 20 and the wall members being in contact with the fluid, of which the temperatures are being measured.

Fig. 2C illustrates a schematic, cross-sectional side view of an embodiment of a housing 4 of a sensor assembly 2 according to the invention corresponding to the one shown in Fig. 2A and Fig. 2B. The components inside the hollow inner portion 26 of the housing 4, however, are slightly different. A PCB 12 extends along the longitudinal axis of the housing 4. A vibration sensing element 16 is mechanically and electrically connected to the PCB 12.

A sensing element 20 comprising an ultrasonic sensor 20 is arranged in the distal portion of the hollow inner portion 26. The sensing element 20 is brought into contact with the bottom wall 8 in the distal end 46 of the housing 4. Accordingly, the position enables optimal conditions for providing dry run detection by using the ultrasonic sensor of the sensing element 20. A thermosensitive sensor 14 is provided in a bore extending parallel to the longitudinal axis of the housing 4. The thermosensitive sensor 14 is electrically connected to the PCB 12 by means of legs 18". A connection ring 13 is sandwiched between a cork plate 100 and an inner support structure of the housing 4. The connection ring 13 is electrically connected to the PCB 12 and to the sensing element 20. The bottom portion of that part of the hollow inner portion 26 of the housing 4 that is arranged above the cork plate 100 is filled with a first filler material (e.g. a resin). Similarly, the top portion of that part of the hollow inner portion 26 of the housing 4 that is arranged above the cork plate 100 is filled with a second filler material (e.g. a resin) ensuring that mechanical vibrations can be transferred from the pump through the housing 4 to the vibration sensing element 16 in an effective manner. Even though not shown, the housing 4 may comprise two sections to be assembled. Hereby, it is possible to ease the mounting of the sensing element 20.

The ultrasonic sensor of the sensing element 20 is configured to be used for dry run detection, whereas the thermosensitive sensor of the sensing element 20 is adapted to measure the temperature of a fluid being in contact with the outside surface of the bottom wall 8. The sensing element 20 is electrically connected to the PCB 12 by means of two legs 18, 18'. The sensing element 20 is arranged in an air-filled cavity.

When Fig. 2A is compared with Fig. 2B, it can be seen that the sensor elements take up less space in Fig. 2B, because the sensing element 20 is a combined sensing element 20 arranged in the same sensor housing member.

Fig. 2D illustrates a perspective top view of the sensing element 20 shown in Fig. 2C. It can be seen that the connection ring 13 is provided with two opposing electrical connection portions 15, 15' configured to establish electrical connection between the legs 18, 18' connected to the sensing element 20 and to the two legs 17, 17' configured to be electrically connected to the PCB (shown in Fig. 2C).

Fig. 3 illustrates a schematic, cross-sectional side view of a multistage pump 30 provided with a sensor assembly 2 according to the invention. The pump 30 is a vertically arranged multistage liquid pump 30 comprising three stages arranged in a sleeve 34 that may be made in stainless steel or another suitable material. Each stage comprises an impeller attached to a centrally arranged shaft 50 extending along the longitudinal axis of the sleeve 34. The shaft 50 is rotatably arranged by means of a number of bearings allowing the shaft 50 to be driven by an electric motor (not shown) arranged above the pump head 36 and the motor stool 38 of the pump 30. The shaft 50 may be mechanically connected to the motor by means of a coupling unit (not shown). The pump head 36 is arranged on the top of the sleeve 34, whereas the motor stool 38 is arranged on the top of the pump head 36.

The pump 30 comprises a pump housing 32 having a flanged inlet port (arranged to the left) and a flanged outlet port (arranged to the right).

The sensor assembly 2 comprises a display unit 28 being electrically connected to the housing of the sensor assembly 2 by means of an electric cable 27. The electric cable 27 is connected to the housing by means of an electric plug provided in the distal end of the cable 27.

The display unit 28 comprises a display 29 and a calculation unit 84 configured to carry out calculations on the basis of sensor data received from the sensor elements arranged in the housing of the sensor assembly 2. Calculations may include any processing task. Such processing task may include comparison with stored data or comparison with data that the calculation unit 84 has access to through one or more externally arranged devices (including a server accessible via the internet). The calculation unit 84 may comprise a battery providing electrical power to the calculation unit 84 and to the housing of the sensor assembly 2 via the cable 27. Although not shown, the display unit 28 may be electrically powered through an additional electrical cable. Electrical power may be supplied from the electrical motor coupled to the shaft 50.

The display unit 28 may comprise a separate user interface (e.g. a keypad). However, in a preferred embodiment according to the invention, the display unit 28 may comprise a touch screen that can display a number of parameters and be used as user interface. The display unit 28 may be a smartphone, a tablet, a PDA or another suitable device.

The housing of the sensor assembly 2 is inserted into a threaded bore provided in the pump head 36. The distal portion of the housing of the sensor assembly 2 protrudes into an inner space 40 of the pump head 36. Accordingly, there is access to the inner space 40 that will be filled with the liquid being pumped by the pump 30 under normal operation. Since the housing of the sensor assembly 2 is screwed into a threaded bore provided in a mechanical structure of the pump 30, vibration signals originating from the motor bearing and from cavitation can reach the sensing elements inside the housing of the sensor assembly 2 as the vibration signals travel along the mechanical structures of the pump housing 32, the sleeve 34, the pump head 36 and the motor stool 38.

It is possible to provide a processing unit inside the housing. Such processing unit may be capable of carrying out any desirable processing signals received by means of sensing elements provided inside the housing of the sensor assembly 2. Processing may include filtering or carrying out any analysis.

Fig. 4A illustrates a schematic, perspective, exploded view of the elements of a housing 4 of a sensor assembly 2 according to the invention. The housing 4 comprises an inner hollow portion and an outer threaded portion 6 configured to be screwed into a threaded bore. The proximal end of the housing 4 is provided with an inner thread configured to receive an outer threaded portion 24 of a socket structure comprising an annular portion 42 and an additional threaded portion 44. A PCB 12 is arranged between the socket structure and the housing 4. The PCB 12 comprises an ultrasonic sensor 10 protruding from the end portion of the PCB 12. The ultrasonic sensor 10 is electrically connected to the PCB by means of two legs. The PCB 12 comprises a thermosensitive sensor 14 and a vibration sensing element 16 attached to the PCB 12. Although not shown, the PCB 12 may be provided with connection structures configured to be electrically connected to corresponding connection structures inside the socket structure.

Fig. 4B illustrates a schematic, perspective, cross-sectional view of the elements of the housing 4 of a sensor assembly 2 shown in Fig. 4A, in an assembled configuration. It can be seen that the ultrasonic sensor 10 abuts the bottom wall 8 and is arranged in the distal end of the housing 4. The PCB 12 extends along the longitudinal axis of the housing 4. The outer threaded portion 24 of the socket structure is screwed into the threaded portion of the hollow inner portion of the housing 4. An O-ring 56 is provided in an annular groove provided next to the outer threaded portion 6 of the housing 4. It can be seen that the annular portion 42 of the socket structure fits an inner annular groove provided at the inner side of the proximal end of the housing 4.

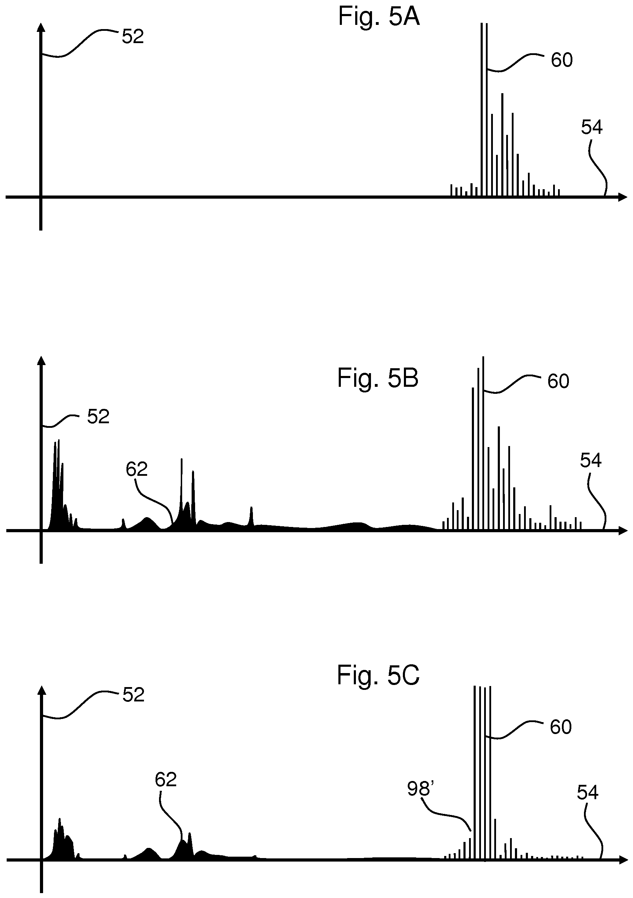

Fig. 5A illustrates a spectral diagram based on spectral analysis of data from an accelerometer attached to a motor of a pump, wherein the detected level 52 is plotted as function of frequency 54. When a motor bearing has a "point damage", the vibration signals and sound originating therefrom will have a periodic structure. Accordingly, the corresponding spectral diagram will have line spectra 60.

Fig. 5B illustrates a spectral diagram based on spectral analysis of data from a sensor assembly according to the invention provided with an accelerometer used as a vibration sensing element. The spectral diagram which is displaying level 52 as function of frequency 54 shows a line spectra 60 corresponding to the one shown in Fig. 5A. The spectral diagram furthermore comprises a noise component 62.

Fig. 5C shows a spectral diagram based on spectral analysis of data from a sensor assembly according to the invention provided with a microphone used as a vibration sensing element. The spectral diagram depicts the measured level 52 as function of frequency 54 and illustrates a line spectra 60 corresponding to the one shown in Fig. 5A and Fig. 5B. The spectral diagram also comprises a noise component 62.

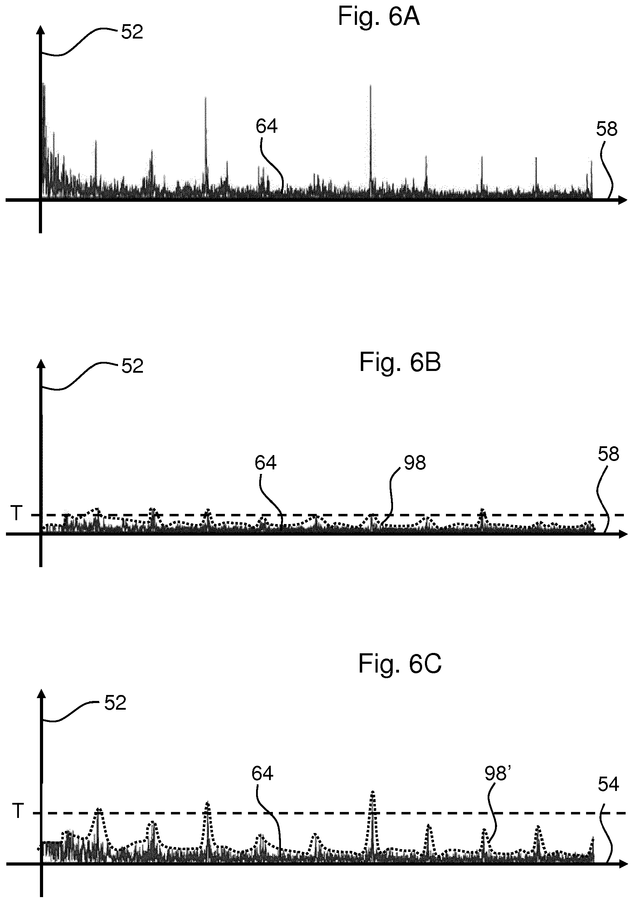

Fig. 6A illustrates a Cepstral diagram based on Cepstral analysis carried out on the basis of data from an accelerometer attached to a motor of a pump, wherein the detected level 52 is plotted as function of quefrency 58. It can be seen that the Cepstral domain signal 64 contains a plurality of spikes that indicate the presence of a motor bearing fault.

Fig. 6B illustrates a Cepstral diagram based on Cepstral analysis carried out on the basis of data from a sensor assembly according to the invention provided with an accelerometer used as a vibration sensing element, wherein the detected level 52 is plotted as function of quefrency 58. The Cepstral domain signal 64 contains a plurality of spikes that indicate the presence of a motor bearing fault. An envelope 98 is indicated by a dotted line.

In one embodiment of a method according to the invention, a definition of a motor bearing fault can be made on the basis of the Cepstral diagram. A motor bearing fault may be defined to be present when a portion of the envelope 98 exceeds a predefined threshold level T. Fig. 6B will reveal that the motor bearing is damaged, since the amplitude of the envelope 98 exceeds the predefined threshold level T.

Fig. 6C illustrates a Cepstral diagram based on Cepstral analysis carried out on the basis of data from a sensor assembly according to the invention provided with a microphone used as a vibration sensing element, wherein the detected level 52 is plotted as function of quefrency 58. It can be seen that the Cepstral domain signal 64 contains a plurality of spikes indicating the presence of a motor bearing fault. An envelope 98' is indicated by a dotted line.

When using the method referred to with reference to Fig. 6B, it can be concluded that a motor bearing fault is present because the envelope 98' exceeds a predefined threshold level T.

When comparing Fig. 6B and Fig. 6C, it can be seen that the spikes occur at the same quefrencies 58. Therefore, it is reasonable to conclude that vibration measurements may be carried out by either an accelerometer or a microphone.

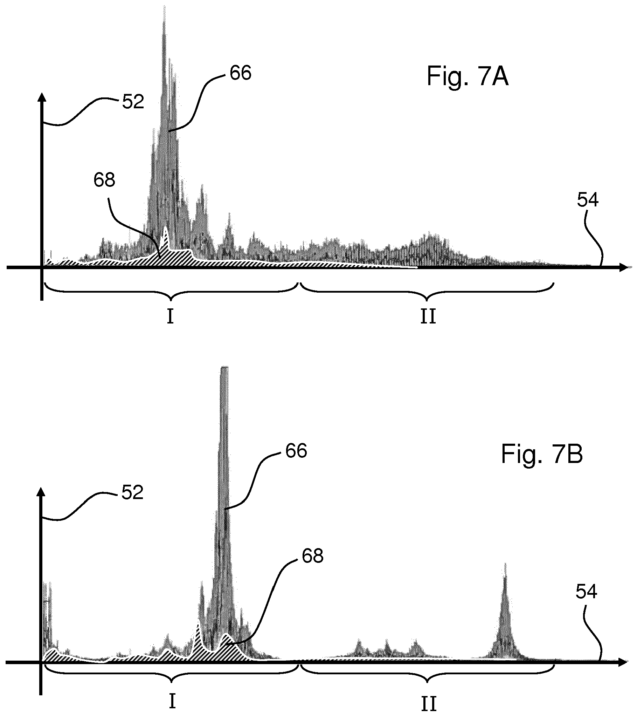

Fig. 7A illustrates a spectral diagram based on spectral analysis of data from an accelerometer attached to a motor of a pump, during cavitation and under normal operation, wherein the detected level 52 is plotted as function of frequency 54. The spectral diagram contains a cavitation signal 66 based on spectral analysis of data during cavitation. The spectral diagram also contains a normal operation signal 68 based on spectral analysis of data during normal operation.

It can be seen that the spectral diagram reveals that there is a relatively high level increase in the frequency band II during cavitation. There seems to be a level increase in the lower frequency band I, however, the relative increase is larger in the higher frequency band II. Therefore, in one embodiment of the method according to the invention, cavitation is defined to be present when the spectral level 52 increases in a predefined frequency band II. The predefined frequency band II may lie within the range 10-20 kHz. In one embodiment of the method according to the invention, cavitation is defined to be present when the spectral level 52 increases in the frequency 15-20 kHz.

Fig. 7B illustrates a spectral diagram based on spectral analysis of data from a sensor assembly according to the invention provided with an accelerometer used as a vibration sensing element, during cavitation and under normal operation, wherein the detected level 52 is plotted as function of frequency 54.

The spectral diagram contains a cavitation signal 66 based on spectral analysis of data during cavitation and a normal operation signal 68 based on spectral analysis of data during normal operation.

The spectral diagram shows that there is a relatively high level increase in the frequency band II during cavitation. Even though there is a level increase in the lower frequency band I, it can be seen that the relative increase is larger in the higher frequency band II. Accordingly, in a preferred embodiment of the method according to the invention, cavitation is defined to be present when the spectral level 52 increases in a predefined frequency band II e.g. within the range 10-20 kHz. Thus, in one embodiment of the method according to the invention, cavitation is defined to be present when the spectral level 52 increases in the frequency 15-20 kHz.

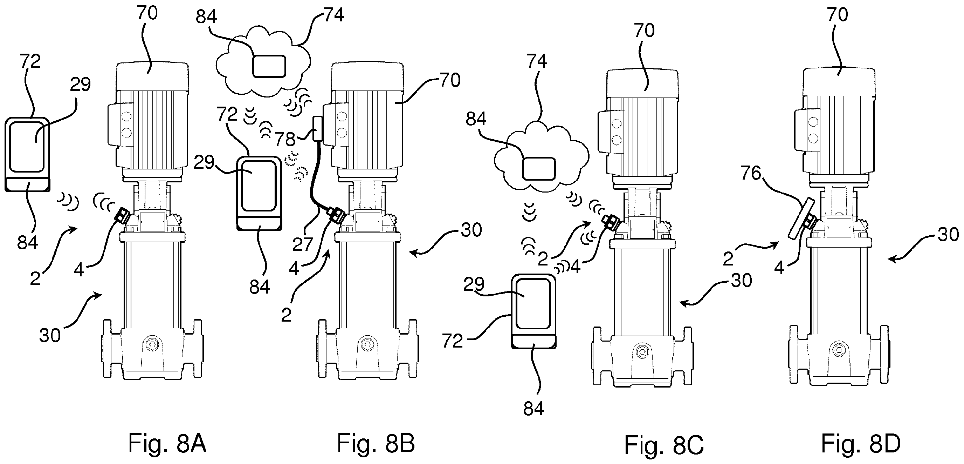

Fig. 8A illustrates a schematic, side view of the elements of a sensor assembly 2 according to the invention, wherein the sensor housing 4 is arranged in a bore of a vertically arranged multistage pump 30 provided with an electric motor 70. The sensor assembly 2 comprises a sensor housing 4 provided with a communication unit configured to communicate wirelessly with an external receiving unit 72 provided with a display 29 and a calculation unit 84. The receiving unit 72 may, however, also be configured to transmit wireless signals, whereas the communication unit in the sensor housing 4 of the sensor assembly 2 may be adapted to receive signals from the external receiving unit 72. Such signals may be a stop signal in case of a critical fault (e.g. a cavitation or a critical motor bearing fault). The receiving unit 72 may be a tablet, a smartphone or another suitable external device.

The communication unit 84 may comprise a processing unit and a storage for storing one or more software programs to carry out any desirable processing. The display unit 29 may be of any suitable type, including a touch screen that may be used to display one or more parameters and as a user interface. The processing unit may preferably be capable of processing data received from the sensing elements in the housing 4 in real time.

Fig. 8B illustrates a schematic, side view of the elements of another sensor assembly 2 according to the invention, wherein the housing 4 is arranged in a bore of a multistage pump 30 and wherein the sensor assembly 2 is configured to communicate with a cloud-based server indicated as a calculation unit 84 accessible via the Internet 74.

The housing 4 is electrically connected to an intermediate box 78 attached to a control box fixed to the motor housing of the motor 70 by means of an electrical cable 27. Accordingly, the sensors in the housing 4 can be powered through the cable 27, and sensor signals received by the sensors can be transferred to the intermediate box 78. It is possible to have a processing unit inside the intermediate box 78 so that the vital calculation can be carried out without any external device. If this is the case, communication with the receiving unit 72 (e.g. a smartphone) and the calculation unit 84 via the Internet 74 may be carried out in order to exchange data or carry out comparisons.

A communication unit configured to wirelessly communicate via the Internet 74 (e.g. to a calculation unit 84 being part of a server or to a receiving unit 72 having a display and a calculation unit 84) is arranged in the intermediate box 78.

Accordingly, calculations and processing may be carried out in either the calculation unit 84 accessible through the Internet 74 or in the calculation unit 84 arranged to wirelessly communicate with the intermediate box 78.

The receiving unit 72 and the internet-based calculation unit 84 are capable of communicating with each other.

Fig. 8C illustrates a schematic, side view of the elements of a further sensor assembly 2 according to the invention, wherein the housing 4 is arranged in a bore of a multistage pump 30 and wherein the sensor assembly 2 is configured to communicate with a cloud-based server 84 constituting a calculation unit 84.

The housing 4 is provided with a number of sensors and a communication unit configured to wirelessly communicate with the cloud-based server 84 constituting the calculation unit 84 and with a calculation unit 84 of a receiving unit 72 (e.g. a smartphone, a tablet or a PDA). The receiving unit 72 comprises a display 29 and a calculation unit 84. The housing 4 may comprise a battery for providing electric power to the sensor elements and the communication unit. Alternatively, electric power may be supplied to the housing 4 via an electric cable (not shown) or via an energy harvesting unit (e.g. a thermoelectric generator).

The method according to the invention may be carried out by using a sensor assembly 2 like the one shown in Fig. 8C. A Cepstral analysis may be carried out in the calculation unit 84 accessible via the Internet 74 or in the calculation unit of the receiving unit 72. It is possible to carry out calculations simultaneously in several locations (e.g. in the calculation unit 84 accessible via the Internet 74 and in the calculation unit of the receiving unit 72). It is possible to exchange data between the calculation unit 84 accessible via the Internet 74 and the receiving unit 72 and to store data in a server accessible via the Internet 74 or in the receiving unit 72. Data may be distributed to other external devices from either the calculation unit 84 accessible via the Internet 74 or the receiving unit 72. It is possible to update software stored on the calculation unit 84 accessible via the Internet 74 or the receiving unit 72 from a centrally arranged server. Hereby, it is possible to ensure that all calculation units 84 are provided with updated software.

Fig. 8D illustrates a schematic, side view of the elements of a sensor assembly 2 according to the invention, wherein the housing 4 is arranged in a bore of a multistage pump 30, and wherein the sensor assembly 2 comprises a display device 76 attached to the housing 4. The user may apply the display device 76 to read parameters (e.g. bearing faults, cavitation, unbalances, dry run, temperature and rotational speed) displayed thereon. The display device 76 may be applied as a user interface and as a calculation unit. Accordingly, all required calculations may be carried out by using the display device 76.

The display device 76 and the housing 4 may be powered by the motor 70 via an electric cable (not shown) or by a battery arranged in the display device 76.

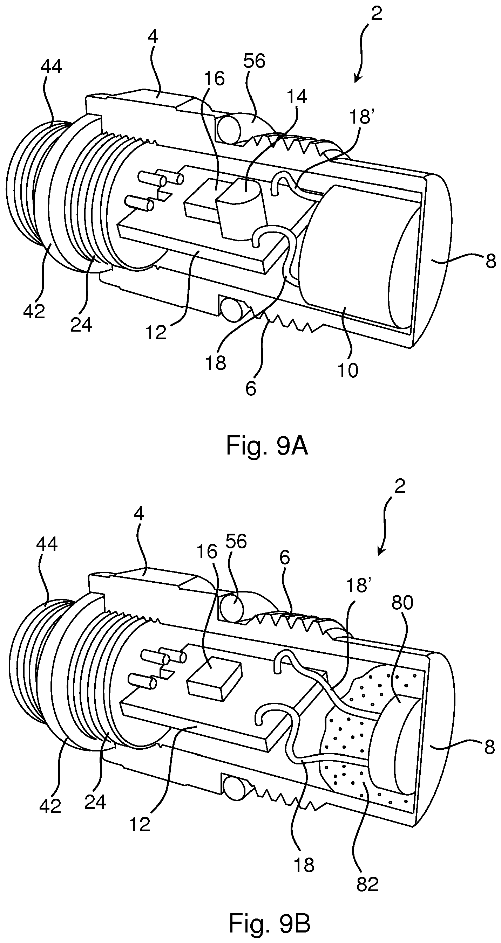

Fig. 9A illustrates a schematic, perspective, cross-sectional view of the elements of a housing 4 of a sensor assembly 2 corresponding to the one shown in Fig. 4B. An ultrasonic sensor 10 is brought into contact with the bottom wall 8 arranged in the distal end of the housing 4. A thermosensitive sensor 14 and vibration sensing element 14 are electrically connected to the PCB 12 extending along the longitudinal axis of the housing 4. The ultrasonic sensor 10 is electrically connected to the PCB 12 by means of two legs 18, 18'. An O-ring 56 is arranged next to an outer threaded portion 6 of the housing 4 for sealing against the bore into which the housing has to be inserted. The proximal end of the housing 4 is provided with an inner thread that has received the outer threaded portion 24 of a socket structure comprising an annular portion 42 and an additional threaded portion 44. Three parallel connection structures extend through the socket structure. Even though it is not shown in Fig. 9A, additional connection elements may electrically connect the PCB 12 and the connection structures extending through the socket structure.

Fig. 9B illustrates a schematic, perspective, cross-sectional view of the elements of a housing 4 of another sensor assembly 2 basically corresponding to the one shown in Fig. 2B. A PCB 12 is arranged in the hollow inner portion of the housing 4. A vibration sensing element 16 is electrically connected and mechanically attached to the PCB 12. A sensing element 20 comprising a thermosensitive sensor and an ultrasonic sensor is arranged in the distal portion of the hollow inner portion of the housing 4 which is filled with an ultrasound gel 82 in order to achieve a good acoustical connection between the ultrasonic sensor of the sensing element 20 and the wall members being in contact with the fluid, of which the temperatures is being measured.

The sensing element 20 is brought into contact with the bottom wall 8 in the distal end 46 of the housing 4 in order to minimize the thermal resistance for achieving the most valid temperature measurement conditions by using the thermosensitive sensor and for achieving optimal conditions for providing dry run detection by using the ultrasonic sensor of the sensing element 20.

The sensing element 20 is electrically connected to the PCB 12 by two legs 18, 18'. The housing 4 and the socket structure attached to its proximal end portion have the same shape as shown in Fig. 9A.

Fig. 10 illustrates a schematic, cross-sectional side view of a multistage pump 30 according to the invention provided. The pump 30 is provided with a sensor assembly 2 according to the invention. The pump 30 corresponds to the vertically arranged multistage liquid pump 30 shown in Fig. 3. The pump 30 has three stages each comprising an impeller attached to a centrally arranged shaft 50 extending along the longitudinal axis of the sleeve 34, into which the stages are arranged. The shaft 50 is rotatably arranged to be driven by an electric motor (not shown) arranged above the pump head 36 and the motor stool 38 of the pump 30. The pump 30 comprises a pump housing 32 having a flanged inlet port (arranged to the left) and a flanged outlet port (arranged to the right).

The sensor assembly 2 comprises a display unit 28 electrically connected to the housing of the sensor assembly 2 via an electric cable 27. The display unit 28 comprises a display 29 and a calculation unit 84 for carrying out calculations on the basis of sensor data from the sensor elements arranged in the housing of the sensor assembly 2.

The housing of the sensor assembly 2 is mounted in a threaded bore provided in the pump head 36. Vibration signals $V_1$ originating from the motor bearing travel along a vibration travel path 86 extending along the motor stool 38 and the pump head 36 and are eventually received by a vibration sensing element in the housing of the sensor assembly 2. Likewise, vibration signals $V_2$ originating from cavitation travel along a vibration travel path 88 extending along the sleeve 34 and are eventually received by a vibration sensing element in the housing of the sensor assembly 2. The vibration signals $V_2$ originating from cavitation also travel along another vibration travel path 90 going through the mechanical structures of the stages and the fluid being pumped by the pump 30.

In order to be able to detect vibration signals $V_1$, $V_2$ having sufficiently large amplitude, the housing of the sensor assembly 2 may be mechanically attached to the pump 30 within a zone Z defined by an upper line $L_2$ and a lower line $L_1$. It can be seen that the housing of the sensor assembly 2 is mounted in a threaded bore provided in the pump head 36 inside the zone Z. By mounting the housing of the sensor assembly 2 in a threaded bore, it is possible to fasten the housing firmly to the pump 30. Accordingly, the risk of experiencing a self-loosening housing is minimised.

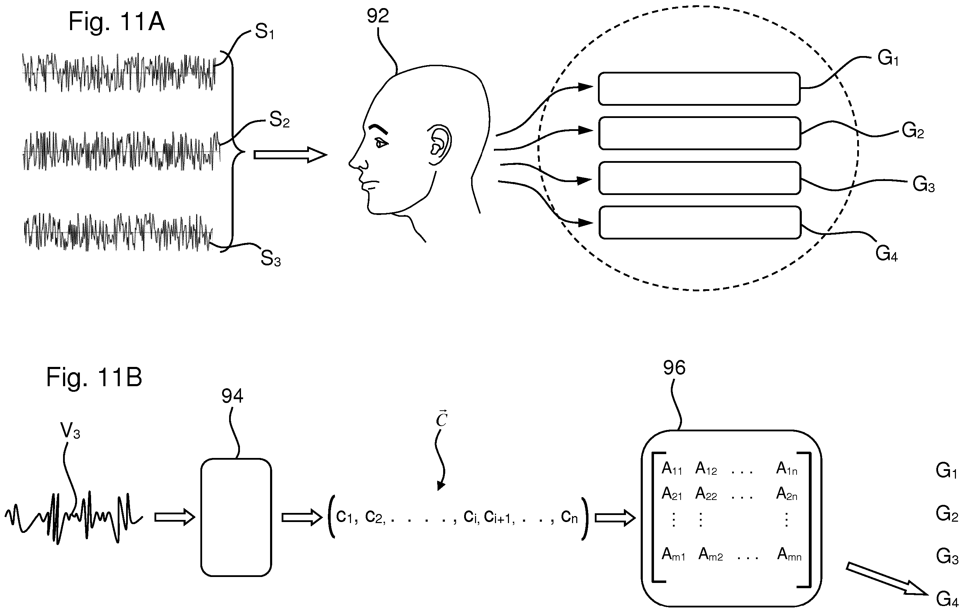

Fig. 11A illustrates a schematic view of a sound analysis carried out to categorize sound signals $S_1$, $S_2$, $S_3$ into a plurality of classes/groups $G_1$, $G_2$, $G_3$, $G_4$, wherein corresponding sensor signals are recorded, and the sound signals are evaluated by using a predefined benchmarking method.

In order to categorize sound signals $S_1$, $S_2$, $S_3$ into a plurality of predefined classes/groups $G_1$, $G_2$, $G_3$, $G_4$ trained service staff 92 having experience with motor bearing faults are presented for the sound signals $S_1$, $S_2$, $S_3$. These trained staff put every sound signals $S_1$, $S_2$, $S_3$ into one of the predefined classes/groups $G_1$, $G_2$, $G_3$, $G_4$ on the basis of their experience. The classes/groups $G_1$, $G_2$, $G_3$, $G_4$ may be:

$G_1$: the bearing is not damaged;
$G_2$: the bearing is slightly damaged; but can be used for some time;
$G_3$: the bearing is moderately damaged and should be replaced;
$G_4$: the bearing is completely damaged and must immediately be replaced.

Instead of using trained service staff 92 to categorize the sound signals $S_1$, $S_2$, $S_3$ into one of the predefined classes/groups $G_1$, $G_2$, $G_3$, $G_4$, it is possible to apply an algorithm. The algorithm may be defined by theoretic considerations. The algorithm may be defined on the basis of data collected by trained service staff and be built by using an artificial neural network or a fuzzy network.

Fig. 11B illustrates a schematic view of a method comprising the step of applying a data table/feature matrix 96 comprising pre-recorded signals or signal patterns $(A_{11}, A_{12},..., A_{1n})$, $(A_{21}, A_{22},..., A_{2n})$,...., $(A_{m1}, A_{m2},..., A_{mn})$ associated with known pump error types and comparing sensor signals $V_3$ with pre-recorded signals or signal patterns $(A_{11}, A_{12},..., A_{1n})$, $(A_{21}, A_{22},..., A_{2n})$,...., $(A_{m1}, A_{m2},..., A_{mn})$ in order to associate the sensor signals $V_3$ with a known sensor error type.

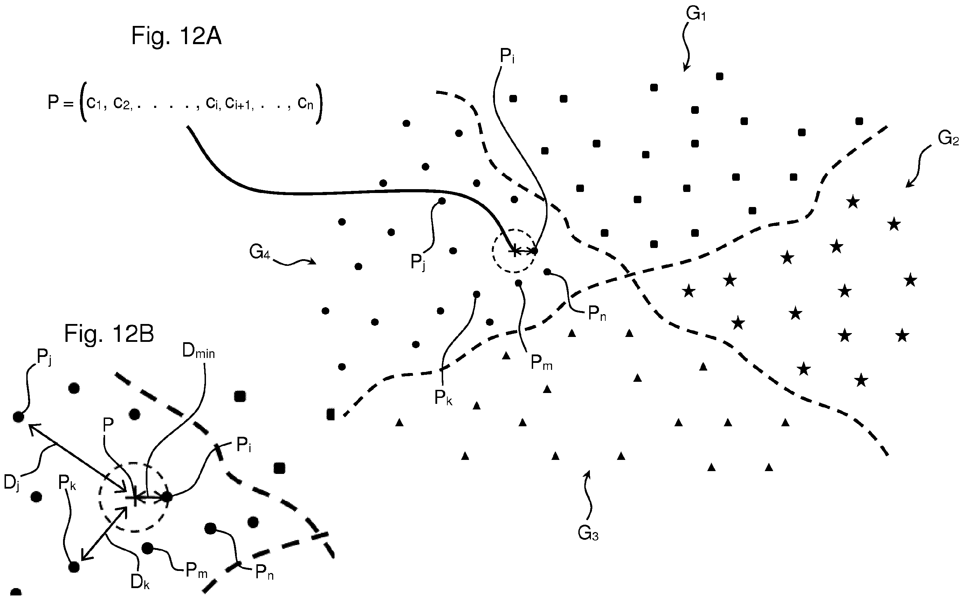

A sensor signal $V_3$ is detected e.g. by using a sensor assembly according to the invention. Hereafter, a feature extractor 94 is used to extract features from the sensor signal $V_3$, hereby generating a feature vector $\vec{C}$. The next step is to use the feature matrix 96 to identify the signal patterns $(A_{11}, A_{12},..., A_{1n})$, $(A_{21}, A_{22},..., A_{2n})$,...., $(A_{m1}, A_{m2},..., A_{mn})$ that is closest to the feature vector $\vec{C}$ in order to categorize the $V_3$ into one of the predefined classes/groups $G_1$, $G_2$, $G_3$, $G_4$ as it will be explained with reference to Fig. 12A and Fig. 12B.

Fig. 12A illustrates a schematic view of the process of associating a detected sensor signal $P = (C_1, C_2, C_3, C_i, C_{i+1}, C_n)$ with a known sensor error type by using a method according to the invention. By using the feature matrix shown in Fig. 11B, one can find that the point $P_i$ is the point from the feature matrix positioned closest to the point P (in the n-dimensional space). Accordingly, this point $P_i$ is selected, and the categorization $G_4$ of $P_i$ is associated to the point P.

In Fig. 12A, the n-dimensional space is separated into four areas $G_1$, $G_2$, $G_3$, $G_4$ corresponding to the four classes/groups $G_1$, $G_2$, $G_3$, $G_4$ explained with reference to Fig. 11A and Fig. 11B. The first group $G_1$ is indicated with squares, the second group $G_2$ is indicated with stars, the third group $G_3$ is indicated with triangles, whereas the fourth group $G_4$ is indicated with circles.

Fig. 12B illustrates a close-up view of the process illustrated in Fig. 12A, in which the point of the feature matrix being positioned closets to $P_i$ is identified. It can be seen that the distance $D_{min}$ between P and $P_i$ is smaller than the distance $D_k$ between P and $P_k$ and the distance $D_j$ between P and $P_j$.

Instead of selecting a single point $P_i$ to categorize the point P, it is possible to select a predefined number (e.g. two, three, four, five or more) of points being located in the shortest distance to the point P. In one embodiment according to the method of the invention, the three points $P_i$, $P_n$, $P_m$ located with the shortest distance to P, are selected, and the average category is calculated. In Fig. 12A and Fig, 12B, all three points $P_i$, $P_n$, $P_m$ have the category $G_4$ having the value 4. Accordingly, the category of the point P is set to $\frac{1}{3}(4+4+4)=4$ .

**List of reference numerals**

| 2 | Sensor assembly |
|---|---|
| 4 | Housing |
| 6 | Threaded portion |
| 8 | Bottom wall |
| 10 | Ultrasonic sensor |
| 12 | Printed circuit board |
| 13 | Connection ring |
| 14 | Thermosensitive sensor |
| 15, 15' | Electrical connection portion |
| 16 | Vibration sensing element |
| 17, 17' | Leg |
| 18, 18', 18" | Leg |
| 19, 21 | Filler material |
| 20 | Sensing element |
| 22 | Gel |
| 24 | Threaded portion |
| 26 | Hollow inner portion |
| 27 | Electric cable |
| 28 | Display unit |
| 29 | Display |
| 30 | Pump |
| 32 | Pump housing |
| 34 | Sleeve |
| 36 | Pump head |
| 38 | Motor stool |
| 40 | Inner space |
| 42 | Annular portion |
| 44 | Threaded portion |
| 46 | Distal end |
| 48 | Proximal end |
| 50 | Shaft |
| 52 | Level |
| 54 | Frequency |
| 56 | O-ring |
| 58 | Quefrency |
| 60 | Line-spectra |
| 62 | Noise signal |
| 64 | Cepstral domain signal |
| A | Section line |

| | | |
|---|---|---|
| I, II | | Frequency area |
| 66 | | Cavitation signal |
| 68 | | Normal operation signal |
| 70 | | Motor |
| 72 | | External receiving unit |
| 74 | | Internet |
| 76 | | Device |
| 78 | | Intermediate box |
| 80 | | Sensor unit |
| 82 | | Ultrasound gel |
| 84 | | Calculation unit |
| 86, 86, 88 | | Vibration travel path |
| 92 | | Person |
| 94 | | Feature extractor |
| 96 | | Feature matrix |
| 98, 98' | | Envelope |
| 100 | | Cork plate |
| $G_1, G_2, G_3, G_4$ | | Group |
| $S_1, S_2, S_3$ | | Sound signal |
| $V_1, V_2, V_3$ | | Vibration signal |
| $C_1, C_2, C_3, C_i, C_{i+1}, C_n$ | | Coordinate |
| $A_{11}, A_{12}, A_{1n}$ | | Coordinate |
| $A_{21}, A_{22}, A_{2n}$ | | Coordinate |
| $A_{m1}, A_{m2}, A_{mn}$ | | Coordinate |
| $\vec{C}$ | | Feature vector |
| $P, P_i, P_j, P_k, P_m, P_n$ | | Point |
| $D_{min}, D_j, D_k$ | | Distance |
| Z | | Zone |
| T | | Threshold level |
| $L_2$ | | Upper line |
| $L_1$ | | Lower line |

**Claims**

1. A sensor assembly (2) configured to perform fault detection in a pump assembly comprising an electric motor (70) and a fluid pump (30), wherein the sensor assembly (2) comprises a housing (4) configured to be attached into a bore provided in the pump (30), wherein one or more vibration sensing element(s) (16) are arranged in the housing (4) and that the sensor assembly (2) comprises a calculation unit (84), wherein the calculation unit (84) is configured to receive sensor signals ($V_1, V_2, V_3$) from the vibration sensing element(s) (16), **characterised in that** the calculation unit (84) is configured to perform calculations and hereby detect motor bearing faults and cavitation on the basis of the sensor signals ($V_1, V_2, V_3$) provided by the one or more vibration sensing element(s) (16).

2. A sensor assembly (2) according to claim 1, **characterised in that** a thermosensitive sensor (14) is arranged in the housing (4), wherein the thermosensitive sensor (14) is arranged to detect the temperature of fluid being pumped by the pump (30).

3. A sensor assembly (2) according to claim 1 or claim 2, **characterised in that** the calculation unit (84) comprises a processing unit configured to receive the signals ($V_1, V_2, V_3$) from the sensing elements (10, 14, 16), wherein the calculation unit (84) is further configured to process the signals ($V_1, V_2, V_3$) and hereby carry out bearing fault detections by using a frequency analysis, wherein the calculation unit (84) is further configured to carry out cavitation detection by using spectral analysis and determine if the spectral level increases in a predefined frequency band.

4. A sensor assembly (2) according to claim 3, **characterised in that** the predefined frequency band is within the range 10-20 kHz.

5. A sensor assembly (2) according to one of the preceding claims, **characterised in that** the calculation unit (84) is arranged outside the pump (30) and connectable to the one or more vibration sensing element(s) (16) through a wired or wireless connection.

6. A sensor assembly (2) according to one of the preceding claims, **characterised in that** the calculation unit (84) is arranged in a separate box (28, 76, 78) arranged outside the pump (30), wherein the calculation unit (84) is electrically connected to the vibration sensing element (16) through an electric cable (27).

7. A sensor assembly (2) according to one of the preceding claims, **characterised in that** the sensor assembly (2) comprises a display unit (28) configured to display one or more of the parameters calculated by the calculation unit (84).

8. A sensor assembly (2) according to one of the preceding claims, **characterised in that** the calculations made by the calculation unit (84) in order to detect both motor bearing faults and cavitation are carried out outside the housing (4).

9. A method for detection of faults in a pump assembly (2) comprising an electric motor (70) and a fluid pump (30), wherein the method comprises the step of providing sensor signals ($V_1$, $V_2$, $V_3$) from at least one vibration sensing element (16) being attached into a bore provided in the pump (30), wherein the method further comprises the following steps:

- applying a calculation unit (84) receiving sensor signals ($V_1$, $V_2$, $V_3$) from the vibration sensitive element (16);
- processing the sensor signals ($V_1$, $V_2$, $V_3$);
- using a frequency analysis to detect motor bearing faults, **characterised by** further comprising
- using a spectral analysis to detect cavitation by determining if the spectral level increases in a predefined frequency band.

10. A method according to claim 9, **characterised in that** the housing (4) is configured to be mechanically attached to a pump head provided with a threaded bore configured to receive the housing (4), wherein the method comprises the step of arranging the housing (4) in the bore arranged in a pump head (36).

11. A method according to claim 9 or 10, **characterised in that** the method comprises the step of applying a bearing fault detection method based on a predefined sound analysis carried out to categorize sound signals ($S_1$, $S_2$, $S_3$) into a plurality of classes/groups ($G_1$, $G_2$, $G_3$, $G_4$), wherein corresponding sensor signals ($V_1$, $V_2$, $V_3$) are recorded, wherein the sound signals ($S_1$, $S_2$, $S_3$) are evaluated by using a predefined benchmarking method benchmarking each sound signal ($S_1$, $S_2$, $S_3$) with a score or category, hereby categorizing the sound signals ($S_1$, $S_2$, $S_3$) and the corresponding sensor signals ($V_1$, $V_2$, $V_3$) into the classes/groups ($G_1$, $G_2$, $G_3$, $G_4$).

12. A method according to claim 10 or claim 11, **characterised in that** the method comprises the step of applying a data table comprising pre-recorded signals or signal patterns associated with known pump error types, wherein the method moreover comprises the step of comparing sensor signals ($V_1$, $V_2$, $V_3$) with pre-recorded signals or signal patterns in order to associate the sensor signals ($V_1$, $V_2$, $V_3$) with a known sensor error type.

13. A method according to one of the claims 11-12, **characterised in that** a feature matrix (96) is generated on the basis of the predefined sound analysis, wherein the feature matrix (96) comprises a plurality of rows or columns corresponding to a number of feature vectors ($\vec{C}$), wherein each feature vector ($\vec{C}$) is generated on the basis of a detected sensor signal ($V_1$, $V_2$, $V_3$), wherein the detected sensor signal ($V_1$, $V_2$, $V_3$) is converted to a feature vector ($\vec{C}$), wherein the measured sensor signal ($V_1$, $V_2$, $V_3$) detected by the at least one vibration sensing element (16) is converted to a measured feature vector ($\vec{C}$) and compared to the feature vectors of the feature matrix (96) by using a distance measurement, wherein the distance measurement determines the distances ($D_{min}$, $D_j$, $D_k$) between the point (P) defined by the measured feature vector ($\vec{C}$) and the points ($P_i$, $P_j$, $P_k$) defined by the feature vectors of the feature matrix (96), wherein a predefined number of points ($P_i$, $P_j$, $P_k$) defined by the feature vector of the feature matrix (96) having the smallest distance ($D_{min}$) to the point (P) defined by the measured feature vector ($\vec{C}$) are found, and wherein the score(s) or categories or a calculated average of these is adapted by the feature vector ($\vec{C}$) converted on the basis of the measured sensor signal ($V_1$, $V_2$, $V_3$) detected by the at least one vibration sensing element (16).

14. A method according to claim 13, **characterised in that** the feature vector ($\vec{C}$) comprises a number of components each representing a scalar derived on the basis of a sensor signal ($V_1$, $V_2$, $V_3$) or a signal processed on the basis of the sensor signal ($V_1$, $V_2$, $V_3$).

15. A method according to one of the claims 10-14, **characterised in that** the method comprises the step of establishing and training an artificial neural network or a fuzzy network to carry out bearing fault detection, wherein the artificial neural network or the fuzzy network comprises information established on the basis of the predefined sound analysis.

16. A method according to one of the claims 11-15, **characterised in that** the method comprises the step of establishing an envelope (98, 98') on the basis of the Cepstral domain signal (64), wherein a motor bearing fault is defined to be present when the amplitude of the envelope (98, 98') exceeds a predefined level (T).

17. A pump (30) comprising a sensor assembly (2) according to one of the claims 1-8, **characterised in that** the housing (4) of the sensor assembly (2) is mounted in a threaded bore provided in the pump head (36), wherein said bore is placed in a zone (Z) of the pump (30), in which zone (Z) the amplitude of the signals (Vi) of the vibrations generated by faulty motor bearings and the amplitude of the signals ($V_2$) generated in case of cavitation in the suction side of the pump (30) have a magnitude sufficiently large to be detected by the vibration sensing elements (16).


**Patentansprüche**

1. Sensoranordnung (2), die zum Ausführen von Fehlererkennung in einer Pumpenanordnung konfiguriert ist, welche einen Elektromotor (70) und eine Fluidpumpe (30) umfasst, wobei die Sensoranordnung (2) ein Gehäuse (4) umfasst, das dazu konfiguriert ist, in einer Bohrung angebracht zu sein, welche in der Pumpe (30) vorgesehen ist, wobei ein oder mehr Schwingungsabfühlelement(e) (16) im Gehäuse (4) angeordnet ist (sind), und wobei die Sensoranordnung (2) eine Berechnungseinheit (84) umfasst, wobei die Berechnungseinheit (84) zum Empfangen von Sensorsignalen ($V_1$, $V_2$, $V_3$) von dem (den) Schwingungsabfühlelement(en) (16) konfiguriert ist, **dadurch gekennzeichnet, dass** die Berechnungseinheit (84) zum Ausführen von Berechnungen und dadurch Erkennen von Motorlagerfehlern und Kavitation auf der Grundlage der Sensorsignale ($V_1$, $V_2$, $V_3$), die durch das eine oder mehr Schwingungsabfühlelement(e) (16) zugeführt werden, konfiguriert ist.

2. Sensoranordnung (2) nach Anspruch 1, **dadurch gekennzeichnet, dass** ein wärmeempfindlicher Sensor (14) im Gehäuse (4) angeordnet ist, wobei der wärmeempfindliche Sensor (14) zum Erkennen der Temperatur von Fluid, dass durch die Pumpe (30) gepumpt wird, angeordnet ist.

3. Sensoranordnung (2) nach Anspruch 1 oder 2, **dadurch gekennzeichnet, dass** die Berechnungseinheit (84) eine Verarbeitungseinheit umfasst, die zum Empfangen der Signale ($V_1$, $V_2$, $V_3$) von den Abfühlelementen (10, 14, 16) konfiguriert ist, wobei die Berechnungseinheit (84) ferner zum Verarbeiten der Signale ($V_1$, $V_2$, $V_3$) und dadurch Ausführen von Lagerfehlererkennungen durch Benutzung einer Frequenzanalyse konfiguriert ist, wobei die Berechnungseinheit (84) ferner zum Ausführen von Kavitationserkennung durch Benutzung von Spektralanalyse und Bestimmen, ob der Spektralpegel in einem vordefinierten Frequenzband zunimmt, konfiguriert ist.

4. Sensoranordnung (2) nach Anspruch 3, **dadurch gekennzeichnet, dass** das vordefinierte Frequenzband im Bereich von 10 bis 20 kHz liegt.

5. Sensoranordnung (2) nach einem der vorhergehenden Ansprüche, **dadurch gekennzeichnet, dass** die Berechnungseinheit (84) außerhalb der Pumpe (30) angeordnet und mit dem (den) einen oder mehr Schwingungsabfühlelement(en) (16) über eine verdrahtete oder drahtlose Verbindung verbindbar ist.

6. Sensoranordnung (2) nach einem der vorhergehenden Ansprüche, **dadurch gekennzeichnet, dass** die Berechnungseinheit (84) in einem separaten Kasten (28, 76, 78) angeordnet ist, der außerhalb der Pumpe (30) angeordnet ist, wobei die Berechnungseinheit (84) über ein Stromkabel (27) elektrisch mit dem Schwingungsabfühlelement (16) verbunden ist.

7. Sensoranordnung (2) nach einem der vorhergehenden Ansprüche, **dadurch gekennzeichnet, dass** die Sensoranordnung (2) eine Anzeigeneinheit (28) umfasst, die zum Anzeigen von einem oder mehr der Parameter, welche durch die Berechnungseinheit (84) berechnet werden, konfiguriert ist.

8. Sensoranordnung (2) nach einem der vorhergehenden Ansprüche, **dadurch gekennzeichnet, dass** die Berechnungen, die durch die Berechnungseinheit (84) zum Berechnen sowohl von Motorlagerfehlern als auch von Kavitation vorgenommen werden, außerhalb des Gehäuses (4) ausgeführt werden.

9. Verfahren zur Erkennung von Fehlern in einer Pumpenbaugruppe (2), die einen Elektromotor (70) und eine Fluidpumpe (30) umfasst, wobei das Verfahren den Schritt des Zuführens von Sensorsignalen ($V_1$, $V_2$, $V_3$) von zumindest einem Schwingungsabfühlelement (16), das in einer Bohrung angebracht ist, welche in der Pumpe (30) vorgesehen ist, umfasst, wobei das Verfahren ferner die folgenden Schritte umfasst:

- Anwenden einer Berechnungseinheit (84), die Sensorsignale ($V_1$, $V_2$, $V_3$) vom Schwingungsabfühlelement (16) empfängt;
- Verarbeiten der Sensorsignale ($V_1$, $V_2$, $V_3$);
- Benutzen einer Frequenzanalyse zum Erkennen von Motorlagerfehlern,

**dadurch gekennzeichnet, dass** es ferner umfasst:

- Benutzen einer Spektralanalyse zum Erkennen von Kavitation durch Bestimmen, ob der Spektralpegel in einem vordefinierten Frequenzband zunimmt.

10. Verfahren nach Anspruch 9, **dadurch gekennzeichnet, dass** das Gehäuse (4) dazu konfiguriert ist, mechanisch an einem Pumpenkopf, der mit einer Gewindebohrung versehen ist, welche zum Aufnehmen des Gehäuses (4) konfiguriert ist, angebracht zu sein, wobei das Verfahren den Schritt des Anordnens des Gehäuses (4) in der Bohrung, die in einem Pumpenkopf (36) angeordnet ist, umfasst.

11. Verfahren nach Anspruch 9 oder 10, **dadurch gekennzeichnet, dass** das Verfahren den Schritt des Anwendens eines Lagerfehlererkennungsverfahrens basierend auf einer vordefinierten Klanganalyse umfasst, die zum Kate-gorisieren von Klangsignalen ($S_1$, $S_2$, $S_3$) in mehrere Klassen/Gruppen ($G_1$, $G_2$, $G_3$, $G_4$) ausgeführt wird, wobei die entsprechenden Sensorsignale ($V_1$, $V_2$, $V_3$) aufgezeichnet werden, wobei die Klangsignale ($S_1$, $S_2$, $S_3$) unter Be-nutzung eines vordefinierten Benchmark-Verfahrens bewertet werden, das jedes Klangsignal ($S_1$, $S_2$, $S_3$) mit einem Wert oder einer Kategorie benchmarkt, wodurch die Klangsignale ($S_1$, $S_2$, $S_3$) und die entsprechenden Sensorsignale ($V_1$, $V_2$, $V_3$) in die Klassen/Gruppen ($G_1$, $G_2$, $G_3$, $G_4$) kategorisiert werden.

12. Verfahren nach Anspruch 10 oder 11, **dadurch gekennzeichnet, dass** das Verfahren den Schritt des Anwendens einer Datentabelle umfasst, die voraufgezeichnete Signale oder Signalmuster, welche mit bekannten Pumpenfehlertypen assoziiert sind, umfasst, wobei das Verfahren zudem den Schritt des Vergleichens von Sensorsignalen ($V_1$, $V_2$, $V_3$) mit voraufgezeichneten Signalen oder Signalmustern umfasst, um die Sensorsignale ($V_1$, $V_2$, $V_3$) mit einem bekannten Sensorfehlertyp zu assoziieren.

13. Verfahren nach einem der Ansprüche 11 bis 12, **dadurch gekennzeichnet, dass** eine Merkmalsmatrix (96) auf der Grundlage der vordefinierten Klanganalyse erstellt wird, wobei die Merkmalsmatrix (96) mehrere Zeilen und Spalten umfasst, die einer Anzahl von Merkmalsvektoren ($\vec{C}$) entsprechen, wobei jeder Merkmalsvektor ($\vec{C}$) auf der Grundlage eines erkannten Sensorsignals ($V_1$, $V_2$, $V_3$) erzeugt wird, wobei das erkannte Sensorsignal ($V_1$, $V_2$, $V_3$) in einen Merkmalsvektor ($\vec{C}$) umgewandelt wird, wobei das gemessene Sensorsignal ($V_1$, $V_2$, $V_3$), das durch das zumindest eine Schwingungsabfühlelement (16) erkannt wurde, in einen gemessenen Merkmalsvektor ($\vec{C}$) umge-wandelt und mit den Merkmalsvektoren der Merkmalsmatrix (96) unter Benutzung einer Entfernungsmessung verglichen wird, wobei die Entfernungsmessung die Entfernungen ($D_{min}$, $D_j$, $D_k$) zwischen dem Punkt (P), der durch den gemessenen Merkmalsvektor ($\vec{C}$) definiert ist, und den Punkten ($P_i$, $P_j$, $P_k$), die durch die Merkmalsvektoren der Merkmalsmatrix (96) definiert sind, bestimmt, wobei eine vordefinierte Anzahl von Punkten ($P_i$, $P_j$, $P_k$), die durch den Merkmalsvektor der Merkmalsmatrix (96) definiert sind, mit der kleinsten Entfernung ($D_{min}$) zum Punkt (P), der durch den gemessenen Merkmalsvektor ($\vec{C}$)) definiert ist, aufgefunden wird, und wobei der (die) Wert(e) oder Kategorien oder ein berechneter Mittelwert derselben durch den Merkmalsvektor ($\vec{C}$) angenommen wird, der auf der Grundlage des gemessenen Klangsignals ($V_1$, $V_2$, $V_3$), das durch das zumindest eine Schwingungsabfühlelement (16) erkannt wurde, umgewandelt wurde.

14. Verfahren nach Anspruch 13, **dadurch gekennzeichnet, dass** der Merkmalsvektor ($\vec{C}$) eine Anzahl von Komponenten umfasst, die jede einen Skalar darstellen, der auf der Grundlage eines Sensorsignals ($V_1$, $V_2$, $V_3$) oder eines Signals, das auf der Grundlage des Sensorsignals ($V_1$, $V_2$, $V_3$) verarbeitet wurde, abgeleitet wird.

**15.** Verfahren nach einem der Ansprüche 10 bis 14, **dadurch gekennzeichnet, dass** das Verfahren den Schritt des Einrichtens und Trainierens eines künstlichen neuronalen Netzwerks oder eines Fuzzy-Netzwerks zum Ausführen von Lagerfehlererkennung umfasst, wobei das künstliche neuronale Netzwerk oder das Fuzzy-Netzwerk Information umfassen, die auf der Grundlage der vordefinierten Klanganalyse erstellt wird.

**16.** Verfahren nach einem der Ansprüche 11 bis 15, **dadurch gekennzeichnet, dass** das Verfahren den Schritt des Einrichtens einer Hülle (98, 98') auf der Grundlage des Cepstraldomainsignals (64) umfasst, wobei ein Motorlagerfehler als vorhanden definiert wird, wenn die Amplitude der Hülle (98, 98') eine vordefinierte Ebene (T) übersteigt.

**17.** Pumpe (30), die eine Sensoranordnung (2) nach einem der Ansprüche 1 bis 8 umfasst, **dadurch gekennzeichnet, dass** das Gehäuse (4) der Sensoranordnung (2) in einer Gewindebohrung angebracht ist, die im Pumpenkopf (36) vorgesehen ist, wobei die Bohrung in einer Zone (Z) der Pumpe (30) platziert ist, wobei in dieser Zone (Z) die Amplitude der Signale ($V_1$) der Schwingungen, die durch fehlerhafte Motorlager erzeugt werden, und die Amplitude der Signale ($V_2$), die im Falle von Kavitation in der Ansaugseite der Pumpe (30) erzeugt werden, eine Größenordnung aufweisen, die groß genug ist, um durch die Schwingungsabfühlelemente (16) erkannt zu werden.


**Revendications**

**1.** Ensemble de capteur (2) configuré pour effectuer une détection de défaillance dans un ensemble de pompe comprenant un moteur électrique (70) et une pompe à fluide (30), dans lequel l'ensemble de capteur (2) comprend un logement (4) configuré pour être fixé dans un alésage prévu dans la pompe (30), dans lequel un ou plusieurs éléments de détection de vibrations (16) sont agencés dans le logement (4) et dans lequel l'ensemble de capteur (2) comprend une unité de calcul (84), dans lequel l'unité de calcul (84) est configurée pour recevoir des signaux de capteur ($V_1$, $V_2$, $V_3$) provenant du ou des éléments de détection de vibrations (16), **caractérisé en ce que** l'unité de calcul (84) est configurée pour effectuer des calculs et détecter ainsi des défaillances de palier de moteur et une cavitation sur la base des signaux de capteur ($V_1$, $V_2$, $V_3$) fournis par les un ou plusieurs éléments de détection de vibrations (16).

**2.** Ensemble de capteur (2) selon la revendication 1, **caractérisé en ce qu'**un capteur thermosensible (14) est agencé dans le logement (4), dans lequel le capteur thermosensible (14) est agencé pour détecter la température d'un fluide pompé par la pompe (30).

**3.** Ensemble de capteur (2) selon la revendication 1 ou la revendication 2, **caractérisé en ce que** l'unité de calcul (84) comprend une unité de traitement configurée pour recevoir les signaux ($V_1$, $V_2$, $V_3$) provenant des éléments de détection (10, 14, 16), dans lequel l'unité de calcul (84) est en outre configurée pour traiter les signaux ($V_1$, $V_2$, $V_3$) et effectuer ainsi des détections de défaillance de palier en utilisant une analyse de fréquence, dans lequel l'unité de calcul (84) est en outre configurée pour effectuer une détection de cavitation en utilisant une analyse spectrale et déterminer si le niveau spectral augmente dans une bande de fréquence prédéfinie.

**4.** Ensemble de capteur (2) selon la revendication 3, **caractérisé en ce que** la bande de fréquence prédéfinie se situe dans la plage de 10 à 20 kHz.

**5.** Ensemble de capteur (2) selon l'une quelconque des revendications précédentes, **caractérisé en ce que** l'unité de calcul (84) est agencée à l'extérieur de la pompe (30) et peut être connectée aux un ou plusieurs éléments de détection de vibrations (16) par l'intermédiaire d'une connexion câblée ou sans fil.

**6.** Ensemble de capteur (2) selon l'une quelconque des revendications précédentes, **caractérisé en ce que** l'unité de calcul (84) est agencée dans un logement séparé (28, 76, 78) agencé à l'extérieur de la pompe (30), dans lequel l'unité de calcul (84) est connectée électriquement à l'élément de détection de vibrations (16) par l'intermédiaire d'un câble électrique (27).

**7.** Ensemble de capteur (2) selon l'une quelconque des revendications précédentes, **caractérisé en ce que** l'ensemble de capteur (2) comprend une unité d'affichage (28) configurée pour afficher un ou plusieurs des paramètres calculés par l'unité de calcul (84).

**8.** Ensemble de capteur (2) selon l'une quelconque des revendications précédentes, **caractérisé en ce que** les calculs effectués par l'unité de calcul (84) afin de détecter à la fois les défaillances de palier de moteur et la cavitation sont effectués à l'extérieur du logement (4).

**9.** Procédé de détection de défaillances dans un ensemble de pompe (2) comprenant un moteur électrique (70) et une pompe à fluide (30), dans lequel le procédé comprend l'étape consistant à fournir des signaux de capteur ($V_1$, $V_2$, $V_3$) provenant d'au moins un élément de détection de vibrations (16) fixé dans un alésage prévu dans la pompe (30), dans lequel le procédé comprend en outre les étapes suivantes consistant à:

- appliquer une unité de calcul (84) recevant des signaux de capteur ($V_1$, $V_2$, $V_3$) provenant de l'élément sensible aux vibrations (16);
- traiter les signaux de capteur ($V_1$, $V_2$, $V_3$);
- utiliser une analyse fréquentielle pour détecter les défaillances de palier de moteur,

**caractérisé en ce qu'**il comprend en outre l'étape consistant à:

- utiliser une analyse spectrale pour détecter la cavitation en déterminant si le niveau spectral augmente dans une bande de fréquence prédéfinie.

**10.** Procédé selon la revendication 9, caractérisé en que le logement (4) est configuré pour être fixé mécaniquement à une tête de pompe munie d'un alésage fileté configuré pour recevoir le logement (4), dans lequel le procédé comprend l'étape consistant à agencer le logement (4) dans l'alésage agencé dans une tête de pompe (36).

**11.** Procédé selon la revendication 9 ou 10, **caractérisé en ce que** le procédé comprend l'étape consistant à appliquer un procédé de détection de défaillance de palier basé sur une analyse sonore prédéfinie effectuée pour catégoriser des signaux sonores ($S_1$, $S_2$, $S_3$) en une pluralité de classes/groupes ($G_1$, $G_2$, $G_3$, $G_4$), dans lequel des signaux de capteur correspondants ($V_1$, $V_2$, $V_3$) sont enregistrés, dans lequel les signaux sonores ($S_1$, $S_2$, $S_3$) sont évalués en utilisant un procédé d'étalonnage prédéfini étalonnant chaque signal sonore ($S_1$, $S_2$, $S_3$) avec un score ou une catégorie, en catégorisant ainsi les signaux sonores ($S_1$, $S_2$, $S_3$) et les signaux de capteur correspondants ($V_1$, $V_2$, $V_3$) dans les classes/groupes ($G_1$, $G_2$, G3, G4).

**12.** Procédé selon la revendication 10 ou la revendication 11, **caractérisé en ce que** le procédé comprend l'étape consistant à appliquer une table de données comprenant des signaux ou des motifs de signaux préenregistrés associés à des types d'erreur de pompe connus, dans lequel le procédé comprend en outre l'étape consistant à comparer des signaux de capteur ($V_1$, $V_2$, $V_3$) avec des signaux ou des motifs de signaux préenregistrés afin d'associer les signaux de capteur ($V_1$, $V_2$, $V_3$) à un type d'erreur de capteur connu.

**13.** Procédé selon l'une des revendications 11 à 12, **caractérisé en ce qu'**une matrice de caractéristiques (96) est générée sur la base de l'analyse sonore prédéfinie, dans lequel la matrice de caractéristiques (96) comprend une pluralité de rangées ou de colonnes correspondant à un certain nombre de vecteurs de caractéristique ($\vec{C}$), dans lequel chaque vecteur de caractéristique ($\vec{C}$) est généré sur la base d'un signal de capteur détecté ($V_1$, $V_2$, $V_3$), dans lequel le signal de capteur détecté ($V_1$, $V_2$, $V_3$) est converti en un vecteur de caractéristique ($\vec{C}$), dans lequel le signal de capteur mesuré ($V_1$, $V_2$, $V_3$) détecté par le au moins un élément de détection de vibrations (16) est converti en un vecteur de caractéristique mesuré ($\vec{C}$) et comparé aux vecteurs de caractéristique de la matrice de caractéristiques (96) à l'aide d'une mesure de distance, dans lequel la mesure de distance détermine les distances ($D_{min}$, $D_j$, $D_k$) entre le point (P) défini par le vecteur de caractéristique mesuré ($\vec{C}$) et les points ($P_i$, $P_j$, $P_k$) définis par les vecteurs de caractéristique de la matrice de caractéristiques (96), dans lequel un nombre prédéfini de points ($P_i$, $P_j$, $P_k$) définis par le vecteur de caractéristique de la matrice de caractéristiques (96) ayant la plus petite distance ($D_{min}$) par rapport au point (P) défini par le vecteur de caractéristique mesuré ($\vec{C}$) sont trouvés, et dans lequel les un ou plusieurs scores ou catégories ou une moyenne calculée de ceux-ci sont adaptés par le vecteur de caractéristique ($\vec{C}$) converti sur la base du signal de capteur mesuré ($V_1$, $V_2$, $V_3$) détecté par les un ou plusieurs éléments de détection de vibrations (16).

**14.** Procédé selon la revendication 13, **caractérisé en ce que** le vecteur de caractéristique ($\vec{C}$) comprend un certain nombre de composantes représentant chacune un scalaire dérivé sur la base d'un signal de capteur ($V_1$, $V_2$, $V_3$) ou d'un signal traité sur la base du signal de capteur ($V_1$, $V_2$, $V_3$).

**15.** Procédé selon l'une quelconque des revendications 10 à 14, **caractérisé en ce que** le procédé comprend l'étape consistant à établir et à entraîner un réseau neuronal artificiel ou un réseau flou pour effectuer une détection de défaillance de palier, dans lequel le réseau neuronal artificiel ou le réseau flou comprend des informations établies sur la base de l'analyse sonore prédéfinie.

16. Procédé selon l'une quelconque des revendications 11 à 15, **caractérisé en ce que** le procédé comprend l'étape consistant à établir une enveloppe (98, 98') sur la base du signal de domaine cepstral (64), dans lequel un défaillance de palier de moteur est défini pour être présent lorsque l'amplitude de l'enveloppe (98, 98') dépasse un niveau prédéfini (T).

17. Pompe (30) comprenant un ensemble de capteur (2) selon l'une quelconque des revendications 1 à 8, **caractérisée en ce que** le logement (4) de l'ensemble de capteur (2) est monté dans un alésage fileté prévu dans la tête de pompe (36), dans laquelle ledit alésage est placé dans une zone (Z) de la pompe (30), zone (Z) dans laquelle l'amplitude des signaux ($V_1$) des vibrations générées par des paliers de moteur défectueux et l'amplitude des signaux ($V_2$) générés en cas de cavitation dans le côté d'aspiration de la pompe (30) ont une amplitude suffisamment grande pour être détectées par les éléments de détection de vibrations (16).

Fig. 1A

A        A

4        2

Fig. 1B

24
48
4
2
26
6
46        8

Fig. 1C

48
2
6
46        8

Fig. 2A

Fig. 2B

Fig. 2C

Fig. 2D

EP 3 563 062 B1

Fig. 3

Fig. 4A

Fig. 4B

Fig. 5A

Fig. 5B

Fig. 5C

## Fig. 6A

## Fig. 6B

## Fig. 6C

Fig. 7A

Fig. 7B

Fig. 8A   Fig. 8B   Fig. 8C   Fig. 8D

Fig. 9A

Fig. 9B

Fig. 10

Fig. 11A

$S_1$

$S_2$

$S_3$

92

$G_1$

$G_2$

$G_3$

$G_4$

Fig. 11B

94

$V_3$

$\vec{C}$

96

$\left( c_1, c_2, \ldots, c_i, c_{i+1}, \ldots, c_n \right)$

$\begin{bmatrix} A_{11} & A_{12} & \ldots & A_{1n} \\ A_{21} & A_{22} & \ldots & A_{2n} \\ \vdots & \vdots & & \vdots \\ A_{m1} & A_{m2} & \ldots & A_{mn} \end{bmatrix}$

$G_1$

$G_2$

$G_3$

$G_4$

Fig. 12A

$G_2$

$G_1$

$P_i$

$P_n$

$P_m$

$G_3$

$P_j$

$P_k$

$G_4$

$$P = \left( c_1,\ c_2,\ \ldots\ ,\ c_i,\ c_{i+1},\ \ldots\ ,\ c_n \right)$$

Fig. 12B

$D_{min}$

$P_i$

$P_n$

$P_m$

$P$

$D_k$

$P_k$

$P_j$

$D_j$

**EP 3 563 062 B1**

**REFERENCES CITED IN THE DESCRIPTION**

**Patent documents cited in the description**

- EP 0742372 B1
- EP 1972793 B1
- EP 1298511 A1
- WO 2015197141 A1